(19) Europäisches Patentamt
European Patent Office
Office européen des brevets

(11) EP 1 953 534 A1

(12) **EUROPEAN PATENT APPLICATION**
published in accordance with Art. 158(3) EPC

(43) Date of publication:
06.08.2008 Bulletin 2008/32

(51) Int Cl.:
*G01N 21/35* (2006.01)

(21) Application number: 06832451.6

(86) International application number:
PCT/JP2006/322390

(22) Date of filing: 09.11.2006

(87) International publication number:
WO 2007/058117 (24.05.2007 Gazette 2007/21)

(84) Designated Contracting States:
AT BE BG CH CY CZ DE DK EE ES FI FR GB GR
HU IE IS IT LI LT LU LV MC NL PL PT RO SE SI
SK TR

(30) Priority: 15.11.2005 JP 2005330281
22.11.2005 JP 2005337790

(71) Applicant: OMRON CORPORATION
Kyoto-shi, Kyoto 600-8530 (JP)

(72) Inventors:
• OHASHI, Katsumi c/o Omron Corporation 801
Shimogyo-ku, Kyoto-shi Kyoto 600-8530 (JP)
• HORINO, Masanobu c/o Omron Corporation 801
Shimogyo-ku, Kyoto-shi Kyoto 600-8530 (JP)
• ONISHI, Yasuhiro c/o Omron Corporation 801
Shimogyo-ku, Kyoto-shi Kyoto 600-8530 (JP)

(74) Representative: Wilhelms · Kilian & Partner
Patentanwälte
Eduard-Schmid-Strasse 2
81541 München (DE)

(54) **SOLDER MATERIAL INSPECTING DEVICE**

(57) Before an electronic component is mounted on a board 2, only a cream solder 3 printed on the board 2 is irradiated with a light beam which the board 2 is scanned based on printing position information obtained by printing position obtaining means such as CAD data, and thereby inspection object intensity of an infrared ray having a specific wave number, which is reflected from the cream solder 3, is detected by the irradiation of the cream solder 3 with the light beam. The cream solder 3 printed on the board 2 is set to an inspection object, and a deterioration parameter indicating a relative degree of deterioration of the cream solder 3 of the inspection object to a cream solder 3 of a comparison object is computed based on comparison object intensity of the infrared ray having the specific wave number and the inspection object intensity. The comparison object intensity of the infrared ray is detected as a reflected light beam when the cream solder 3 of the comparison object is irradiated with the light beam.

Fig. 1

EP 1 953 534 A1

**Description**

TECHNICAL FIELD

The present invention relates to a device inspecting a degree of deterioration of a solder material.

BACKGROUND ART

In a production line of a printed board (hereinafter simply referred to as "board"), electronic components are mounted on the board by performing a print step of printing a solder material on the board, a mounting step of mounting the electronic components on the printed solder material, and a reflow step of soldering the electronic components onto the board.

For example, the print step is performed as follows. Firstly, a metal mask is disposed on the board, and cream solder which is the solder material is supplied to a surface of the metal mask. Then, a squeegee is caused to abut on and slide onto the metal mask surface. This enables the squeegee to press the cream solder against the metal mask surface to be rotated and moved. Because a hole corresponding to a wiring pattern of the board is made in the metal mask, the cream solder pushed out from the hole by the pressing force of the squeegee is printed on the board (see paragraph [0011] of Patent Document 2).

Since generally the metal mask is continuously used for the large amount of boards while the same solder material is mounted, the solder material is repeatedly rotated and moved in every print. As a result, the solder material is gradually deteriorated, and the deteriorated solder material causes a defect on the board.

Accordingly, in order to prevent generation of the defect on the board or to maintain print quality in the print step, a degree of deterioration of the solder material is analyzed on the metal mask. When the degree of deterioration of the solder material is increased, work of exchanging the solder material on the metal mask becomes very important.

It is known that, with the deterioration of the solder material, viscosity of the solder material is increased and oxidation proceeds to lower reduction power. For example, it is known that the defect such as "chipping" and "blur" is easily generated on the board after the print step when the solder material having the high viscosity is printed on the board, the defect such as "solder ball" and "unmelted solder" is easily generated on the board after the reflow step when the solder material having advanced oxidation is printed on the board, and the defect such as "deterioration of wetability" is easily generated on the board after reflow step when the solder material having the lowered reduction power is printed on the board.

Thus, because the viscosity, degree of oxidation, and reduction power of the solder material are correlated with the degree of defect generation on the board, the viscosity, degree of oxidation, and reduction power become important indexes for evaluating the degree of deterioration of the solder material.

As described in Patent Document 1, a method of performing titration of the sampled solder material to measure a solder material (flux) acid value, that is, a method of performing analysis by so-called off-line measurement in which the measurement is performed out of a board manufacturing line can be cited as an example of a method of analyzing the degree of deterioration of the solder material such as the cream solder. However, in this method, preparation of a reagent and the like are required, which results in a problem in that additional labor hour is required to perform the measurement.

On the other hand, as described in Patent Documents 2 and 3, there is also a method of analyzing the degree of deterioration of the solder material in order to reduce the additional labor hour for the measurement, that is, a method of enabling in-line measurement in which the measurement for inspecting the degree of deterioration of the solder material is performed in the manufacturing line.

Patent Document 2 discloses the method in which, in the print step performed to the board, the solder material flowing on the squeegee surface is irradiated with a laser beam emitted from a laser sensor to measure a flow speed of the solder material, thereby measuring the viscosity of the solder material. However, in the method of Patent Document 2, there is generated a problem that a variation in measurement is increased according to a squeegee driving state.

On the other hand, Patent Document 3 discloses the technique of using an ultraviolet photoelectron spectroscopy to measure a surface oxidation ratio of the solder material in an environment near the actual production step. The technique of Patent Document 3 enables the in-line evaluation independent on the squeegee drive like the method of Patent Document 2. At the same time, from the standpoint of work health, the technique of Patent Document 3 is undesirable because of use of a harmful ultraviolet ray.

Patent Document 1: Japanese Patent Laid-Open Publication No. 08-20434 (published data: March 4, 1996)

Patent Document 2: Japanese Patent Laid-Open Publication No. 05-99831 (published data: April 23, 1993)

Patent Document 3: Japanese Patent Laid-Open Publication No. 10-82737 (published data: March 31, 1998)

DISCLOSURE OF THE INVENTION

PROBLEMS TO BE SOLVED BY THE INVENTION

In view of the foregoing, an object of the invention is to provide a solder material inspecting device, in which the labor hour necessary for the inspection is suppressed, desirable work health is realized, and measurement accuracy is enhanced.

MEANS FOR SOLVING THE PROBLEMS

In order to solve the problems, a solder material inspecting device according to the invention includes printing position obtaining means for obtaining information on a printing position of a solder material printed on a board; a light source which emits a light beam only to the solder material printed on the board while scanning the board with the light beam based on the printing position information obtained by the printing position obtaining means; and an intensity detecting unit which detects inspection object intensity of an infrared ray having a specific wave number, the infrared ray being reflected from the solder material by the emission of the light beam from the light source, wherein an absorbance of the infrared ray having the specific wave number in the solder material of the inspection object and the inspection object intensity are supplied as measurement values, the absorbance being obtained based on the inspection object intensity.

A solder material inspecting device according to the invention is characterized by including printing position obtaining means for obtaining information on a printing position of a solder material printed on a board; a light source which emits a light beam only to the solder material printed on the board while scanning the board with the light beam based on the printing position information obtained by the printing position obtaining means; an intensity detecting unit which detects inspection object intensity of an infrared ray having a specific wave number, the infrared ray being reflected from the solder material by the emission of the light beam from the light source; and a solder deterioration computing unit which sets the solder material printed on the board to an inspection object, and computes a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam.

The solder material is deteriorated by the increase in viscosity caused by repeated print or a chemical reaction during the storage, and the deteriorated solder material causes the defect on the board. The accurate inspection of the degree of deterioration of the solder material becomes important in order to prevent the generation of the defect on the board or to maintain the print quality in the print step.

The inventors have considered that a time when the degree of deterioration of the solder material is inspected is preferably close to a time when the reflow is performed as much as possible, and the inventors have considered that the solder material actually printed on the board is preferably used as the inspection object. Although the inventors have considered that a so-called noncontact measurement method of irradiating the solder material with the light beam to perform the inspection is preferably used in inspecting the degree of deterioration of the solder material actually printed on the board, on the other hand, from the standpoint of work health, the method in which the ultraviolet ray is used is undesirable like the technique of Patent Document 3. Accordingly, the inventors have focused on the fact that the viscosity, degree of oxidation, and reduction power of the solder material can be analyzed by the infrared spectroscopy, and the inventors have analyzed the degree of deterioration of the solder material.

However, because the surfaces of the board and mounted electronic component are made of a resin, a resist, and the like, when the board on which the solder material is printed is simply irradiated with the light beam, the infrared spectra of the board and mounted electronic component is integrated as a noise, which results in a problem of the lowered measurement accuracy.

Therefore, in order to solve the problem, the invention includes the printing position obtaining means for obtaining information on a printing position of the solder material printed on the board and the light source which emits the light beam only to the solder material printed on the board based on the printing position information obtained by the printing position obtaining means, whereby only the solder material printed on the board is irradiated with the light beam to achieve the improvement of the measurement accuracy without picking up the noise.

As used herein, the printing position obtaining means shall mean drawing data, such as CAD data, which is used in producing the metal mask or board used in printing the solder material. For example, in the case where the CAD data of the metal mask is used as the printing position obtaining means, because an arrangement of a hole (opening) in the metal mask and dimensions of the opening are inputted as the data, the printing position of the solder material can be specified on the board when the CAD data of the metal mask is utilized. Because positioning marks are provided in the board and the metal mask for the purpose of the positioning, the printing position information can be formed by a coordinate having an origin of the positioning mark, the dimensions of the opening, and the like.

The light source is a lamp which emits the light beam. For example, a ceramic light source is used, and the light source is configured to emit the light beam while scanning the board in the invention. As used herein, the scanning shall mean that the light source is moved on the board while emitting the light beam. In the invention, the light source is configured to move on the board while emitting the light beam only to the solder material printed on the board. For the configuration in which only the solder material is irradiated with the light beam, for example, the light beam is intermittently emitted by controlling the light source, or the light source continuously emits the light beam to provide light shielding means for intermittently shielding the light beam emitted from the light source, whereby only the solder material printed on the board can be irradiated with the light beam. The light shielding means is formed by an opening and closing shutter, the solder material is irradiated with the light beam when the opening and closing shutter is in an opened state, and the light beam is shielded when the opening and closing shutter is in a closed state.

In the invention, an input unit which can specify a measurement object area may be provided, the measurement object area being a scanning range of the light source in the solder material printed on the board. An operator can arbitrarily set the measurement object area.

In the invention, the viscosity, degree of oxidation, and reduction power of the solder material are analyzed by the infrared spectroscopy, thereby analyzing the degree of deterioration of the solder material. The high-quality solder material has the low viscosity, the low degree of oxidation, and the high reduction power. However, when the solder material is deteriorated, the viscosity and the degree of oxidation are increased while the reduction power is lowered. Therefore, the inventors have considered that the degree of deterioration of the solder material can be determined when at least one of the viscosity, the degree of oxidation, and the reduction power is analyzed.

The viscosity, degree of oxidation, and reduction power of the solder material can be analyzed by the infrared spectroscopy for the following reasons.

When the solder material is continuously used while exposed to external air, a contained metal is oxidized and a contained acid (for example, carboxylic acid) is changed into a salt. That is, in the solder material, the contained metal oxide is increased, an acid content is decreased, and a salt content is increased. The metal oxide is also called oxidized metal.

In the solder material, the degree of oxidation is enhanced by the increase in metal oxide, the viscosity is enhanced by the increase in salt, and the reduction power is lowered by the decrease in acid content.

Accordingly, in the solder material of the inspection object, the viscosity, degree of oxidation, and reduction power of the solder material can be inspected when the metal oxide content and the acid and salt contents can be analyzed, and the degree of deterioration of the solder material can be inspected when the metal oxide content and the acid and salt contents are used as indexes. That is, the metal oxide content, the acid content, and the salt content in the solder material indicate the degree of deterioration (viscosity, degree of oxidation, and reduction power) of the solder material.

The inventors have focused on the fact that at least one of the metal oxide, acid, and salt contents can be analyzed by the infrared spectroscopy and the inventors have realized the invention.

An absorption amount of infrared ray of a specific wave number in the solder material is changed according to the metal oxide, acid, and salt contents in the solder material, and therefore intensity of the specific wave number of the infrared ray reflected from the solder material is changed. This is because the metal oxide, acid, and salt contained in the solder material have characteristics of absorbing the infrared rays of the specified wave number bands.

For example, a solder material (such as new solder material and solder material used 100 times) having a state different from a state (degree of deterioration) of the solder material of the inspection object is set to a comparison object, and the metal oxide, acid, and salt contents in the solder material of the inspection object can be relatively analyzed with respect to the solder material of the comparison object based on the intensity (inspection object intensity and comparison object intensity) of the infrared rays having the specific wave numbers, which are reflected from the inspection object and the comparison object, so that the viscosity, degree of oxidation, and reduction power of the solder material of the inspection object can be relatively inspected. Therefore, the degree of deterioration (viscosity, degree of oxidation, and reduction power) of the solder material of the inspection object can be relatively inspected with respect to the solder material of the comparison object. The contents indicate the degree of deterioration (viscosity, degree of oxidation, and reduction power) of the solder material. For example, the comparison object intensity can be detected by the same way as the inspection object intensity. The comparison object intensity may be detected in the same way when the inspection object intensity is detected, or the comparison object intensity may previously be detected and stored in storage means.

The relative content is supplied as a deterioration parameter indicating the relative degree of deterioration of the solder material of the inspection object to the solder material of the comparison object. Therefore, a user of the device can analyze the relative content of the solder material of the inspection object to the solder material of the comparison object using the supplied deterioration parameter, and the relative degree of deterioration of the solder material of the inspection object can be inspected to the solder material of the comparison object.

The light beam with which the solder material is irradiated may be the infrared ray having the specific wave number or the light beam including the infrared ray having the specific wave number.

According to the invention, because the titration work disclosed in Patent Document 1 is not required, the labor hour necessary for the work can be suppressed in comparison with the method of Patent Document 1, and the high-accuracy measurement can be performed in comparison with the method of Patent Document 2. Additionally, because the ultraviolet ray is not used, the desirable work health is realized in comparison with the method of Patent Document 3.

In the invention, because it is only necessary to be able to analyze at least one of the metal oxide, acid, and salt contents, the specific wave number may be a wave number contained in a wave number band of the infrared ray which is absorbed by at least one of the metal oxide, acid, and salt contents contained in the solder material.

Examples of the metal oxide include a tin oxide and a zinc oxide. For the acid contained in the solder material, a carboxylic acid can be listed as the acid having the large content. Therefore, the carboxylic acid is preferably used as the acid. For the salt contained in the deteriorated solder material, a carboxylate can be listed as the salt having the large content. Therefore, the carboxylate is preferably used as the salt.

The specific wave number may be a wave number included in at least one of ranges of 520 $cm^{-1}$ to 700 $cm^{-1}$, 1270 $cm^{-1}$ to 1430 $cm^{-1}$, 1500 $cm^{-1}$ to 1650 $cm^{-1}$, and 1665 $cm^{-1}$ to 1730 $cm^{-1}$.

This is because the zinc oxide and zinc oxide have a characteristic in which the infrared ray in the range of 520 $cm^{-1}$ to 700 $cm^{-1}$ is absorbed, and this is because the carboxylic acid has a characteristic in which the infrared ray in the range of 1665 $cm^{-1}$ to 1730 $cm^{-1}$ is absorbed. This is because the carboxylate has a characteristic in which the infrared ray in the ranges of 1270 $cm^{-1}$ to 1430 $cm^{-1}$ and 1500 $cm^{-1}$ to 1650 $cm^{-1}$ are absorbed.

The deterioration parameter may be supplied by a procedure of obtaining a difference between the inspection object intensity and the comparison object intensity or a procedure of obtaining a ratio of the inspection object intensity and the comparison object intensity.

The difference or ratio is a parameter indicating a degree of difference of absorbance of the infrared ray having the specific wave number between the solder material of the inspection object and the solder material of the comparison object. That is, according to the difference or ratio, the differences in content of the metal oxide, carboxylic acid, and carboxylate between the solder material of the comparison object and the solder material of the inspection object can be analyzed, the viscosity, degree of oxidation, and reduction power of the solder material of the inspection object to the solder material of the comparison object can be relatively inspected, and the degree of deterioration (viscosity, degree of oxidation, and reduction power) of the solder material of the inspection object can be relatively inspected.

The difference may be slightly generated between the intensity of the infrared ray included in the light beam with which the comparison object is irradiated and the intensity of the infrared ray included in the light beam with which the inspection object is irradiated. In such cases, the difference is included in the difference between the detected inspection object intensity and the detected comparison object intensity.

Therefore, in the solder material inspecting device, preferably, the solder material inspecting device sets a reference wave number which is a wave number different from the specific wave number, the intensity detecting unit detects third intensity of the infrared ray having the reference wave number, the infrared ray being reflected from the solder material of the inspection object, and the solder deterioration computing unit corrects at least one of the inspection object intensity and a comparison object intensity depending on a degree of a difference between fourth intensity of the infrared ray having the reference wave number and the third intensity, the fourth intensity of the infrared ray being detected as a light beam reflected from the solder material of the inspection object when the solder material of the comparison object to the inspection object is irradiated with the light beam.

The deterioration parameter may be obtained by one of a difference and a ratio of a first infrared absorbance of the specific wave number in the solder material of the inspection object and second infrared absorbance of the specific wave number in the solder material of the inspection object, the first infrared absorbance being obtained based on the inspection object intensity, the second infrared absorbance being obtained based on the comparison object intensity.

The difference between or ratio of the first infrared absorbance and the second infrared absorbance is a parameter indicating the degree of difference of absorbance of the infrared ray having the specific wave number between the solder material of the inspection object and the solder material of the comparison object. Accordingly, according to the difference or ratio, the differences in content of the metal oxide, carboxylic acid, and carboxylate between the solder material of the comparison object and the solder material of the inspection object can be analyzed, the viscosity, degree of oxidation, and reduction power of the solder material of the inspection object to the solder material of the comparison object can be relatively inspected, and the degree of deterioration (viscosity, degree of oxidation, and reduction power) of the solder material of the inspection object can be relatively inspected.

The difference may be slightly generated between the intensity of the infrared ray included in the light beam with which the comparison object is irradiated and the intensity of the infrared ray included in the light beam with which the inspection object is irradiated. In such cases, the difference is included in the difference between the detected inspection object intensity and the detected comparison object intensity, and the difference is included in the difference between the first infrared absorbance and the second infrared absorbance.

Therefore, in the solder material inspecting device, preferably, the solder material inspecting device sets a reference wave number which is a wave number different from the specific wave number, the intensity detecting unit detects third intensity of the infrared ray having the reference wave number, the infrared ray being reflected from the solder material of the inspection object, the solder deterioration computing unit obtains a third infrared absorbance of the reference wave number in the solder material of the inspection object based on the third intensity, the solder deterioration computing unit obtains a fourth infrared absorbance of the reference wave number in the solder material of the inspection object based on fourth intensity of the infrared ray having the reference wave number, the fourth intensity of the infrared ray having the reference wave number being detected as a reflected light beam when a solder material of a comparison object to the solder material of the inspection object is irradiated with the light beam, and the solder deterioration computing unit corrects at least one of the first infrared absorbance and the second infrared absorbance depending on a degree of a difference between the third infrared absorbance and the fourth infrared absorbance.

The solder material inspecting device according to the invention includes a light source which emits a light beam to a board before reflow while scanning the board with the light, at least a solder material being printed on the board; an intensity detecting unit which detects measurement intensity, the measurement intensity being an intensity of an infrared ray having a specific wave number, the infrared ray being reflected from the board by the emission of the light beam from the light source, the solder material being printed on the board; and intensity extraction means for extracting inspection object intensity of the infrared ray having the specific wave number from the measurement intensity detected by the intensity detecting unit, the infrared ray being as a reflected light beam detected only from the solder material; wherein an absorbance of the infrared ray having the specific wave number in the solder material of the inspection object and the inspection object intensity are supplied as measurement values, the absorbance being obtained based on the inspection object intensity.

The solder material inspecting device according the invention is characterized by including a light source which emits a light beam to a board before reflow while scanning the board with the light, at least a solder material being printed on the board; an intensity detecting unit which detects measurement intensity, the measurement intensity being an intensity of an infrared ray having a specific wave number, the infrared ray being reflected from the board by the emission of the light beam from the light source, the solder material being printed on the board; intensity extraction means for extracting inspection object intensity of the infrared ray having the specific wave number from the measurement intensity detected by the intensity detecting unit, the infrared ray being as a reflected light beam detected only from the solder material; and a solar deterioration computing unit which sets the solder material printed on the board to an inspection object, the solar deterioration computing unit computing a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam.

In the invention, similarly to the solder material inspecting device which irradiates the solder material with the light beam to inspect the degree of deterioration of the solder material, the solder material printed on the board is set to the inspection object, and the degree of deterioration of the solder material is inspected by the infrared spectroscopy. However, only the solder material printed on the board is not irradiated with the light beam, but the board on which the solder material is printed is continuously irradiated with the light beam while the light beam is scanned, and the inspection object intensity of the infrared ray having the specific wave number, which is the light beam detected only from the solder material, is extracted from the measurement intensity which is the intensity of the infrared ray having the specific wave number as the reflected light beam.

For example, it is assumed that a certain range of the board is irradiated with the light beam while the light beam is scanned and the intensity of the infrared ray having the specific wave number as the reflected light beam is detected. When the electronic component is mounted on the board in the range while the solder material is interposed therebetween, not only the light beam reflected from the solder material but also the light beam reflected from the electronic component are included in the light beam reflected from the board when the light beam is irradiated with scanning, and the intensity detecting unit detects the intensity of the infrared ray having the specific wave number, in which all the reflected light beams are included. It is difficult that the detected intensity is directly used to inspect the degree of deterioration of the solder material. However, because the inspection object intensity of the infrared ray having the specific wave number which is as the reflected light beam detected only from the solder material is included in the detected intensity, the degree of deterioration of the solder material can easily be inspected when the inspection object intensity can be extracted. Therefore, the intensity extraction means for extracting the inspection object intensity of the infrared ray having the specific wave number, which is as the reflected light beam detected only from the solder material, from the detected measurement intensity, is provided in the invention. The solder material printed on the board on which the electronic component is mounted can also be dealt with as the inspection object by providing the intensity extraction means. Therefore, the inspection can be performed immediately before the reflow to improve the measurement accuracy.

For the method of extracting the inspection object intensity, preferably, a storage unit in which intensity of the infrared ray having the specific wave number is previously stored as a board intensity is included, the intensity of the infrared ray being reflected from the board irradiated with the light beam, and the intensity extraction means extracts the inspection object intensity by computing a difference between the measurement intensity and the board intensity stored in the storage unit. The board on which the solder material of the inspection object is printed may be used as the board, or any board may be used as long as the intensity of the infrared ray having the specific wave number reflected only from the board can be detected.

Furthermore, preferably, a storage unit in which intensity of the infrared ray having the specific wave number is stored as solder intensity is included, the intensity of the infrared ray being reflected from a solder material irradiated with the light beam, and the intensity extraction means extracts the inspection object intensity by comparing an increasing and decreasing pattern of a signal of the solder intensity stored in the storage unit to an increasing and decreasing pattern of a signal of the measurement intensity. The solder material is used to observe how an intensity signal of the reflected infrared ray having the specific wave number has the increasing and decreasing pattern when the solder material is irradiated with the light beam. The new solder material may also be used. Preferably the solder material of the comparison object is used, because the comparison object intensity can be utilized. According to this method, even if the electronic components and the like exist on the board, the inspection object intensity can be extracted to perform the inspection immediately before the reflow, so that the measurement accuracy can further be improved. The inspection object intensity can be extracted with no influence of the deterioration of the board.

Alternatively, for the method of extracting the inspection object intensity, the intensity detecting unit detects all the pieces of measurement intensity which are the intensity of the infrared ray reflected from the board on which the solder material is printed using the light beam emitted from the light source, the intensity extraction means compares a predetermined threshold to the intensity of the infrared ray having the reference wave number which is a wave number except for the specific wave number in all the pieces of measurement intensity detected by the intensity detecting unit, the intensity of the infrared ray having the reference wave number is set to the solder intensity when the intensity of the infrared ray having the reference wave number is not more than the threshold, and may extract the inspection object intensity of the infrared ray having the specific wave number from the solder intensity. Because solder material reflection brightness is extremely lower than board reflection brightness, the inspection object intensity can be extracted by the method. The intensity of the light beam having the reference wave number reflected from the solder material and the intensity of the light beam having the reference wave number reflected from the board are measured, and the threshold is previously obtained as a value which can distinguished between intensity of the light beam reflected from the solder material and the intensity of the light beam reflected from the board, and may previously be set in the storage means or the like.

Alternatively, for another method of extracting the inspection object intensity, the summation of the pieces of intensity of the reflected light beams having the specific wave numbers are obtained instead of the intensity of the reflected light beam having the reference wave number, the threshold is similarly obtained by an experiment or the like, and the intensity of the light beam reflected from the solder material may be similarly extracted by the threshold. An average value of all the pieces of measurement intensity is utilized instead of the intensity of the reflected light beam having the reference wave number, the threshold is similarly obtained by the experiment or the like, and the intensity of the light beam reflected from the solder material may be similarly extracted by the threshold.

Alternatively, an input unit which can specify the measurement object area may be included. The measurement object area is a range scanned by the light source in the solder material printed on the board.

The solder deterioration computing unit may be realized by a computer. In such cases, a control program which realizes the solder deterioration computing unit in the computer, and a computer-readable recording medium in which the control program is recorded shall be included in the scope of the invention.

The solder material inspecting method according to the invention is characterized by including obtaining information on a printing position of a solder material printed on a board; emitting a light beam only to the solder material printed on the board while scanning the board with the light beam based on the obtained printing position information; detecting inspection object intensity of an infrared ray having a specific wave number, the infrared ray being reflected from the solder material by the emission of the light beam from the light source; and supplying an absorbance of the infrared ray having the specific wave number in the solder material of the inspection object and the inspection object intensity as measurement values, the absorbance being obtained based on the inspection object intensity.

The solder material inspecting method according to the invention is characterized by including obtaining information on a printing position of a solder material printed on a board; emitting a light beam only to the solder material printed on the board while scanning the board with the light beam based on the obtained printing position information; detecting inspection object intensity of an infrared ray having a specific wave number, the infrared ray being reflected from the solder material by the emission of the light beam from the light source; setting the solder material printed on the board to an inspection object; and computing a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam.

The solder material inspecting method of the invention can be realized by the solder material inspecting device which irradiates only the solder material with the light beam to inspect the degree of deterioration of the solder material, and the solder material inspecting device is described in detail above.

The solder material inspecting method according to the invention is characterized by including emitting a light beam to a board before reflow while scanning the board with the light, at least a solder material being printed on the board; detecting measurement intensity, the measurement intensity being an intensity of an infrared ray having a specific wave number, the infrared ray being reflected from the board by the emission of the light beam from the light source, and the solder material being printed on the board; extracting inspection object intensity of the infrared ray having the specific wave number from the detected measurement intensity, the infrared ray being a reflected light beam detected only from the solder material; and supplying an absorbance of the infrared ray having the specific wave number in the solder material of the inspection object and the inspection object intensity as measurement values, the absorbance being obtained based on the inspection object intensity.

The solder material inspecting method according to the invention is characterized by including emitting a light beam to a board before reflow while scanning the board with the light, at least a solder material being printed on the board; detecting measurement intensity which is an intensity of an infrared ray having a specific wave number, the infrared ray being reflected from the board by the emission of the light beam from the light source, the solder material being printed on the board; extracting inspection object intensity of the infrared ray having the specific wave number from the detected measurement intensity, the infrared ray being a reflected light beam detected only from the solder material; setting the solder material printed on the board to an inspection object; and computing a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam.

The solder material inspecting method of the invention can be realized by the solder material inspecting device, which continuously irradiates the solder material with the light beam while the light beam is scanned, and is configured to extract the inspection object intensity of the infrared ray having the specific wave number which is the detected light beam reflected only from the solder material. The solder material inspecting device is described in detail above.

Thus, in the invention, only the solder material printed on the board is irradiated with the light beam while the light beam scanned on the board based on the printing position information, and the inspection object intensity of the infrared ray having the specific wave number is detected from the light beam reflected from only the solder material. Therefore, because the in-line measurement is enabled, the labor hour necessary for the inspection can be suppressed, a measurement time point can brought closer to the reflow step, and the improvement of the measurement accuracy is achieved. Furthermore, the infrared absorbance of the specific wave number obtained based on the inspection object intensity in the solder material of the inspection object and the inspection object intensity are supplied as the measurement value. That is, from the standpoint of work health, the preferable measurement is performed by the infrared spectroscopy because the ultraviolet ray is not used during the measurement.

In the invention, the board on which at least the solder material is printed is irradiated with the light beam while scanning the light beam, and the measurement intensity is detected by the light beam irradiation. The measurement intensity is the intensity of the infrared ray having the specific wave number reflected from the board on which the solder material is printed. Then, the inspection object intensity of the infrared ray having the specific wave number which is as the detected light beam reflected from the solder material is extracted from the detected measurement intensity. Therefore, the solder material printed on the board on which the electronic component is mounted can also be dealt with as the inspection object, so that the inspection can be performed immediately before the reflow to improve the measurement accuracy.

In order to achieve the object, the solder material inspecting device according to the invention inspects a degree of deterioration of a solder material by using a printing mask and a squeegee, the solder material being printed on a board with a pattern hole filled therewith, the printing mask having at least one pattern hole while being overlapped on the board, the squeegee being slid on a surface of the printing mask surface, the solder material inspecting device includes a detection unit which detects that the squeegee ends the print; a floodlighting unit which emits a light beam to a solder material of an inspection object filling an inspection hole among the pattern holes when receiving a signal of the print end from the detection unit; and an intensity detecting unit which detects inspection object intensity of an infrared ray having a specific wave number, the infrared ray being reflected from the solder material of the inspection object by the emission of the light beam, wherein at least one of an absorbance of the infrared ray having the specific wave number in the solder material of the inspection object and the inspection object intensity is supplied as a measurement value, the absorbance being obtained based on the inspection object intensity.

In the solder material inspecting device according to the invention, preferably, the solder material inspecting device sets a reference wave number which is a wave number different from the specific wave number, the intensity detecting unit detects inspection object reference intensity of the infrared ray having the reference wave number, the infrared ray being reflected from the solder material of the inspection object, and the solder material inspecting device corrects at least one of the inspection object intensity and a comparison object intensity depending on a degree of a difference between comparison object reference intensity of the infrared ray having the reference wave number and the inspection object reference intensity, the comparison object reference intensity of the infrared ray being detected as a light beam reflected from the solder material of the inspection object when a solder material of a comparison object is irradiated with the light beam.

The solder material inspecting device according to the invention inspects a degree of deterioration of a solder material by using a printing mask and a squeegee, the solder material being printed on a board with a pattern hole filled therewith, the printing mask having at least one pattern hole while being overlapped on the board, the squeegee being slid on a surface of the printing mask surface, the solder material inspecting device is characterized by including a detection unit which detects that the squeegee ends the print; a floodlighting unit which emits a light beam to a solder material of an inspection object filling an inspection hole among the pattern holes when receiving a signal of the print end from the detection unit; an intensity detecting unit which detects inspection object intensity of an infrared ray having a specific wave number, the infrared ray being reflected from the solder material of the inspection object by the emission of the light beam; and a processing unit which supplies a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam.

The pattern hole is a hole made in a printing mask (printing plate such as a metal mask), and the pattern hole corresponding to a point where the solder material is printed on the board is made with the printing mask overlapped on the board. Usually the plural pattern holes are made in the printing mask. When the squeegee is slid on the printing mask surface, the pattern holes are sequentially filled with the solder material from the pattern hole closer to a moving start position of the squeegee.

In the invention, the floodlighting unit emits the light beam to the solder material with which the pattern hole (inspection hole) is filled, and the intensity detecting unit detects the inspection object intensity of the reflected infrared ray having the specific wave number, thereby inspecting the degree of deterioration of the solder material. The solder material with which the pattern hole is filled can be set to the inspection object for the following reasons.

In the case where the inspection is performed by accepting the light beam reflected from the inspection object, when the inspection object is in the flat state as much as possible, diffuse reflection is not generated and the inspection result is obtained with high accuracy.

Accordingly, in the invention, preferably, the measurement accuracy is improved when the surface of the solder material irradiated with the light beam emitted from the floodlighting unit is in the flat state as much as possible.

At this point, in the board production line, the surface of the solder material which is the inspection object is in the flattest state until immediately before the printing mask is detached from the board after the print is ended. During the period, the pattern hole is filled with the solder material, the squeegee evens irregularities of the surface of the solder material, and the solder material is regulated from the outside by the pattern hole. Therefore, the surface of the solder material can substantially be kept flat.

The good measurement accuracy is obtained when the time point at which the degree of deterioration of the solder material is measured is brought closer to the reflow step. In order to obtain the better measurement accuracy, after the printing mask is detached from the board, preferably, the measurement is performed until immediately before the reflow step from the mounting step. However, on the other hand, when the print is ended to detach the printing mask from the board, the solder material with which the pattern hole is filled is released from the regulation of the pattern hole. Because the solder material is in a creamy state, the solder material hangs by the self weight, and the resultant surface of the solder material possibly becomes uneven.

Accordingly, in the invention, in order that the measurement can be performed while the surface of the solder material of the inspection object is substantially kept flat, the solder material is maintained such that the pattern hole is filled with the solder material of the inspection object, thereby improving the measurement accuracy (hereinafter the measurement method is referred to as "noncontact measurement method").

Therefore, in the invention, the detection unit is provided to detect the print end. For example, a photoelectric sensor, an ultrasonic sensor, and an infrared sensor can be used as the detection unit. The squeegee is slid on the printing mask to print the solder material on the board. When the detection unit is placed at a position where the squeegee stops the sliding, the squeegee sliding stop, that is, the print end can be detected.

Previously an inspecting person can arbitrarily set the inspection hole among the pattern holes filled with the solder material of the inspection object, the floodlighting unit irradiates the set inspection hole with the light beam, and the intensity detecting unit detects the intensity of the reflected infrared ray. The plural inspection holes may be set. In such cases, the floodlighting unit and the intensity detecting unit may be set to each inspection hole, or the one floodlighting unit and the one intensity detecting unit may be moved. When the plural inspection hole are set, the degree of deterioration of the solder material can be analyzed in each print position of the solder material on the board, and a distribution of the degree of deterioration can be obtained in each inspection position.

Thus, when the inspection hole is set in the pattern hole, the degree of deterioration of the actually printed solder material can be inspected. Alternatively, a recess is separately formed within a range where the squeegee is slid, and the solder material with which the recess is filled may be measured.

In the invention, the viscosity, degree of oxidation, and reduction power of the solder material are analyzed by the infrared spectroscopy, thereby analyzing the degree of deterioration of the solder material.

In the invention, the floodlighting unit irradiates the solder material of the inspection object with the light beam, and the intensity detecting unit detects the inspection object intensity of the infrared ray having the specific wave number which is reflected from the solder material of the inspection object.

At this point, the floodlighting unit is a lamp emitting the light beam and, for example, a ceramic light source can be applied. The floodlighting unit may be configured so as to directly receive a print end signal from the detection unit, or the floodlighting unit may be configured so as to indirectly receive the print end signal through a control device. When the floodlighting unit receives the print end signal, the floodlighting unit is configured so as to emit the light beam to the inspection hole. When the light beam is emitted only in receiving the print end signal, saving of power consumption and suppression of the heat generation are achieved in comparison with the case where the inspection hole is always irradiated with the light beam.

The intensity detecting unit is formed by an infrared sensor such as a thermal type element such as a collector element and a thermopile or a quantum type element such as MCT (photoconductive cell, HgCdTe). The intensity detecting unit detects the intensity (inspection object intensity) of the infrared ray having the specific wave number which is reflected from the solder material of the inspection object.

The deterioration parameter may be supplied by the procedure of obtaining the difference between or ratio of the inspection object intensity and the comparison object intensity.

The difference or ratio is a parameter indicating a degree of difference of absorbance of the infrared ray having the specific wave number between the solder material of the inspection object and the solder material of the comparison object. That is, according to the difference or ratio, the differences in content of the metal oxide, carboxylic acid, and carboxylate between the solder material of the comparison object and the solder material of the inspection object can be analyzed, the viscosity, degree of oxidation, and reduction power of the solder material of the inspection object to the solder material of the comparison object can relatively be inspected, and the degree of deterioration (viscosity, degree of oxidation, and reduction power) of the solder material of the inspection object can be relatively inspected.

The difference may be slightly generated between the intensity of the infrared ray included in the light beam with which the comparison object is irradiated and the intensity of the infrared ray included in the light beam with which the inspection object is irradiated. In such cases, the difference is included in the difference between the detected inspection object intensity and the detected comparison object intensity.

Therefore, in the solder material inspecting device according to the invention, preferably, the solder material inspecting device sets a reference wave number which is a wave number different from the specific wave number, the intensity detecting unit detects inspection object reference intensity of the infrared ray having the reference wave number, the infrared ray being reflected from the solder material of the inspection object, and the processing unit corrects at least one of the inspection object intensity and a comparison object intensity depending on a degree of a difference between comparison object reference intensity of the infrared ray having the reference wave number and the inspection object reference intensity, the comparison object reference intensity of the infrared ray being detected as a light beam reflected from the solder material of the inspection object when a solder material of a comparison object to the solder material of the inspection object is irradiated with the light beam.

The deterioration parameter may be obtained by one of the difference between or ratio of the first infrared absorbance of the specific wave number in the solder material of the inspection object obtained based on the inspection object intensity and the second infrared absorbance of the specific wave number in the solder material of the comparison object obtained based on the comparison object intensity.

The difference between or ratio of the first infrared absorbance and the second infrared absorbance is a parameter indicating the degree of difference of absorbance of the infrared ray having the specific wave number between the solder material of the inspection object and the solder material of the comparison object. Accordingly, according to the difference or ratio, the differences in content of the metal oxide, carboxylic acid, and carboxylate between the solder material of the comparison object and the solder material of the inspection object can be analyzed, the viscosity, degree of oxidation, and reduction power of the solder material of the inspection object to the solder material of the comparison object can be relatively inspected, and the degree of deterioration (viscosity, degree of oxidation, and reduction power) of the solder material of the inspection object can be relatively inspected.

The difference may be slightly generated between the intensity of the infrared ray included in the light beam with which the comparison object is irradiated and the intensity of the infrared ray included in the light beam with which the inspection object is irradiated. In such cases, the difference is included in the difference between the detected inspection object intensity and the detected comparison object intensity, and the difference is included in the difference between the first infrared absorbance and the second infrared absorbance.

Therefore, in the solder material inspecting device according to the invention, preferably, the solder material inspecting device sets a reference wave number which is a wave number different from the specific wave number, the intensity detecting unit detects inspection object reference intensity of the infrared ray having the reference wave number, the infrared ray being reflected from the solder material of the inspection object, and the processing unit obtains a third infrared absorbance of the reference wave number in the solder material of the inspection object based on the third intensity, the processing unit obtains a fourth infrared absorbance of the reference wave number in the solder material of the inspection object based on fourth intensity of the infrared ray having the reference wave number, the fourth intensity of the infrared ray having the reference wave number being detected as a reflected light beam when a solder material of a comparison object to the solder material of the inspection object is irradiated with the light beam, and the processing unit corrects at least one of the first infrared absorbance and the second infrared absorbance depending on a degree of a difference between the third infrared absorbance and the fourth infrared absorbance.

The processing unit may be implemented by a computer. In such cases, a control program which realizes the processing unit in the computer, and a computer-readable recording medium in which the control program is recorded shall be included in the scope of the invention.

The solder material inspecting device according to the invention inspects a degree of deterioration of a solder material by using a printing mask and a squeegee, the solder material being printed on a board with a pattern hole filled therewith, the printing mask having the pattern hole while being overlapped on the board, the squeegee being slid on a surface of the printing mask surface, while the printing mask is formed longer in a print direction of the squeegee rather than the board when the printing mask is overlapped on the board, a transmission portion is provided in a portion where the printing mask is not overlapped on the board, the solder material of the inspection object is placed on the transmission portion by the squeegee at a time when the print is ended, the solder material inspecting device includes a detection unit which detects that the squeegee ends the print; a floodlighting unit which emits the light beam from a backside of the printing mask to the solder material of the inspection object placed on the transmission portion when receiving the signal of the print end from the detection unit; and an intensity detecting unit which detects inspection object intensity of an infrared ray having a specific wave number, the infrared ray being reflected from the solder material of the inspection object by the emission of the light beam, wherein at least one of an absorbance of the infrared ray having the specific wave number in the solder material of the inspection object and the inspection object intensity is supplied as a measurement value, the absorbance being obtained based on the inspection object intensity.

The solder material inspecting device according to the invention inspects a degree of deterioration of a solder material by using a printing mask and a squeegee, the solder material being printed on a board with a pattern hole filled therewith, the printing mask having the pattern hole while being overlapped on the board, the squeegee being slid on a surface of the printing mask surface, while the printing mask is formed longer in a print direction of the squeegee rather than the board when the printing mask is overlapped on the board, a transmission portion is provided in a portion where the printing mask is not overlapped on the board, the solder material of the inspection object is placed on the transmission portion by the squeegee at a time the print is ended, wherein the solder material inspecting device is characterized by including a detection unit which detects that the squeegee ends the print; a floodlighting unit which emits the light beam from a backside of the printing mask to the solder material of the inspection object placed on the transmission portion when receiving the signal of the print end from the detection unit; an intensity detecting unit which detects inspection object intensity of an infrared ray having a specific wave number, the infrared ray being reflected from the solder material of the inspection object by the emission of the light beam; and a processing unit which supplies a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam.

The solder material inspecting device according to the invention inspects a degree of deterioration of a solder material by using a printing mask and a first squeegee, the solder material being printed on a board with a pattern hole filled therewith, the printing mask having the pattern hole while being overlapped on the board, the first squeegee being slid on a surface of the printing mask surface, while the printing mask is formed longer in a print direction of the first squeegee rather than the board when the printing mask is overlapped on the board, a transmission portion is provided in a portion where the printing mask is not overlapped on the board, the solder material of the inspection object is placed on the transmission portion by the first squeegee at a time when the print is ended, the solder material inspecting device includes a detection unit which detects that the first squeegee ends the print; a floodlighting unit which emits the light beam from a backside of the printing mask to the solder material of the inspection object placed on the transmission portion when receiving the signal of the print end from the detection unit; an intensity detecting unit which detects inspection object intensity of an infrared ray having a specific wave number, the infrared ray being reflected from the solder material of the inspection object by the emission of the light beam; and a second squeegee which squeegees the solder material of the inspection object placed on the transmission portion by movement in an opposite direction to a moving direction of the first squeegee after the intensity detecting unit detects the inspection object intensity, wherein at least one of an absorbance of the infrared ray having the specific wave number in the solder material of the inspection object and the inspection object intensity are supplied as a measurement value, the absorbance being obtained based on the inspection object intensity.

The solder material inspecting device according to the invention inspects a degree of deterioration of a solder material by using a printing mask and a first squeegee, the solder material being printed on a board with a pattern hole filled therewith, the printing mask having the pattern hole while being overlapped on the board, the first squeegee being slid on a surface of the printing mask surface, while the printing mask is formed longer in a print direction of the first squeegee rather than the board when the printing mask is overlapped on the board, a transmission portion is provided in a portion where the printing mask is not overlapped on the board, the solder material of the inspection object is placed on the transmission portion by the first squeegee at a time when the print is ended, the solder material inspecting device includes a detection unit which detects that the first squeegee ends the print; a floodlighting unit which emits the light beam from a backside of the printing mask to the solder material of the inspection object placed on the transmission portion when receiving the signal of the print end from the detection unit; an intensity detecting unit which detects inspection object intensity of an infrared ray having a specific wave number, the infrared ray being reflected from the solder material of the inspection object by the emission of the light beam; a processing unit which supplies a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam; and a second squeegee which squeegees the solder material of the inspection object placed on the transmission portion by movement in an opposite direction to a moving direction of the first squeegee after the intensity detecting unit detects the inspection object intensity.

In the invention, not the noncontact measurement method but a so-called contact measurement method is adopted.

That is, the transmission portion is provided in the printing mask, the solder material is placed on the transmission portion by the squeegee, and the solder material placed on the transmission portion is irradiated from the backside of the printing mask to detect the inspection object intensity of the infrared ray which is as the reflected light beam.

In the printing mask used in the contact measurement method, the printing mask is formed longer in the squeegee print direction rather than the board when the printing mask is overlapped on the board, and a portion where the printing mask is not overlapped on the board is formed on the print end position side of the printing mask. The transmission portion is provided in the portion where the printing mask is not overlapped on the board, the solder material is placed on the transmission portion by the squeegee when the print is ended to stop the sliding of the squeegee. The transmission portion is made of a material transmitting the light beam, and the light beam can be transmitted between the backside and surface side of the printing mask. Therefore, when the floodlighting unit irradiates the transmission portion with the light beam from the backside of the printing mask, the light beam is transmitted through the transmission portion, the solder material placed on the transmission portion is irradiated with the light beam from the backside, and the intensity detecting unit detects the inspection object intensity of the infrared ray having the specific wave number which is reflected from the solder material of the inspection object.

Thus, in the invention, the inspection is performed while the transmission portion and the solder material are brought into contact with each other. Therefore, when the surface (hereinafter referred to as "placement surface") on which the solder material is placed is formed flat in the transmission portion, the surface (hereinafter referred to as "irradiation surface") irradiated with the light beam in the solder material of the inspection object becomes even along the placement surface by the self weight.

Accordingly, in the invention, the improvement of the measurement accuracy is achieved without performing the work of particularly straightening the irradiation surface.

In the invention, preferably, the squeegee placing the solder material of the inspection object on the transmission portion while performing the print is set to a first squeegee, and a second squeegee squeeging the solder material placed on the transmission portion after the inspection is included. The first squeegee may squeegee solder material after the inspection. However, when the second squeegee is provided, while the second squeegee squeegees the solder material, the first squeegee can be returned to the print start position for the next print. Therefore, work efficiency is improved in the print step and the inspection step. For example, the second squeegee is disposed at a position where the second squeegee faces the first squeegee, the second squeegee is slid in the opposite direction to the first squeegee sliding direction to squeegee the solder material placed on the transmission portion, and the second squeegee may be formed so as to be inclined toward the opposite direction to the sliding direction.

Alternatively, the second squeegee squeegees the solder material after the inspection, the second squeegee is slid on the printing mask surface in the opposite direction to the first squeegee print direction, and the solder material can also be printed on the board. Therefore, the improvement of the work efficiency is further achieved in the print step and the inspecting step.

Preferably, the transmission portion is placed at a print end position of the squeegee or the first squeegee. This is because the solder material is pressed against the transmission portion by a self weight.

Preferably, in the transmission portion, a surface (placement surface) on which the solder material of the inspection object is placed is made flush with the printing mask surface. Therefore, the solder material placed on the transmission portion can easily be squeegeed by the second squeegee after the inspection.

Preferably, the transmission portion may be formed by a prism made of ZnSe and Ge. In such cases, the reflection is performed for plural times in the prism, the placement surface is irradiated with the light beam for plural times. When the floodlighting unit and the intensity detecting unit are disposed so as to detect the inspection object intensity of the infrared ray which is as the reflected light beam, preferably, the further improvement of the measurement accuracy is achieved.

Because the infrared spectroscopy is used in the invention, the same description as the noncontact measurement method holds for the invention.

The solder material inspecting method according to the invention includes inspecting a degree of deterioration of a solder material by using a printing mask and a squeegee, the solder material being printed on a board with a pattern hole filled therewith, the printing mask having at least one pattern hole while being overlapped on the board, the squeegee being slid on a surface of the printing mask surface, and the solder material inspecting method includes a detection step of detecting that the squeegee ends the print; a floodlighting step of emitting a light beam to a solder material of an inspection object when receiving a signal of the print end from the detection unit; and an intensity detecting step of detecting inspection object intensity of an infrared ray having a specific wave number, the infrared ray being reflected from the solder material of the inspection object by the emission of the light beam, wherein an absorbance of the infrared ray having the specific wave number in the solder material of the inspection object and the inspection object intensity are supplied as measurement values, the absorbance being obtained based on the inspection object intensity.

The solder material inspecting method according to the invention includes inspecting a degree of deterioration of a solder material by using a printing mask and a squeegee, the solder material being printed on a board with a pattern hole filled therewith, the printing mask having at least one pattern hole while being overlapped on the board, the squeegee being slid on a surface of the printing mask surface, and the solder material inspecting method is characterized by including a detection step of detecting that the squeegee ends the print; a floodlighting step of emitting a light beam to a solder material of an inspection object when receiving a signal of the print end from the detection unit; an intensity detecting step of detecting inspection object intensity of an infrared ray having a specific wave number, the infrared ray being reflected from the solder material of the inspection object by the emission of the light beam; and a processing step of supplying a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam.

The invention is a solder material measurement method in which the noncontact measurement method is adopted, and the solder material measurement method of the invention can be realized by the solder material measurement device of the invention in which the noncontact measurement method is utilized.

The solder material inspecting method according to the invention includes inspecting a degree of deterioration of a solder material by using a printing mask and a squeegee, the solder material being printed on a board with a pattern hole filled therewith, the printing mask having the pattern hole while being overlapped on the board, the squeegee being slid on a surface of the printing mask surface, while the printing mask is formed longer in a print direction of the squeegee rather than the board when the printing mask is overlapped on the board, a transmission portion is provided in a portion where the printing mask is not overlapped on the board, the solder material of the inspection object is placed on the transmission portion by the squeegee at a time the print is ended, the solder material inspecting method includes a detection step of detecting that the squeegee ends the print; a floodlighting step of emitting a light beam to a solder material of an inspection object when receiving a signal of the print end from the detection unit; and an intensity detecting step of detecting inspection object intensity of an infrared ray having a specific wave number, the infrared ray being reflected from the solder material of the inspection object by the emission of the light beam, wherein an absorbance of the infrared ray having the specific wave number in the solder material of the inspection object and the inspection object intensity are supplied as measurement values, the absorbance being obtained based on the inspection object intensity.

The solder material inspecting method according to the invention includes inspecting a degree of deterioration of a solder material by using a printing mask and a squeegee, the solder material being printed on a board with a pattern hole filled therewith, the printing mask having the pattern hole while being overlapped on the board, the squeegee being slid on a surface of the printing mask surface, while the printing mask is formed longer in a print direction of the squeegee rather than the board when the printing mask is overlapped on the board, a transmission portion is provided in a portion where the printing mask is not overlapped on the board, the solder material of the inspection object is placed on the transmission portion by the squeegee at a time the print is ended, and the solder material inspecting method is characterized by including a detection step of detecting that the squeegee ends the print; a floodlighting step of emitting a light beam to a solder material of an inspection object when receiving a signal of the print end from the detection unit; an intensity detecting step of detecting inspection object intensity of an infrared ray having a specific wave number, the infrared ray being reflected from the solder material of the inspection object by the emission of the light beam; and a processing step of supplying a deterioration parameter based on comparison object intensity of the infrared ray having the specific wave number and the inspection object intensity, the deterioration parameter indicating a relative degree of deterioration of the solder material of the inspection object to a solder material of a comparison object, the comparison object intensity of the infrared ray being detected as a reflected light beam when the solder material of the comparison object is irradiated with the light beam.

The invention is a solder material measurement method in which the contact measurement method is adopted, and the solder material measurement method of the invention can be realized by the solder material measurement device of the invention in which the contact measurement method is utilized.

Thus, in the invention, the squeegee detects the print end, the solder material with which the inspection hole is filled or the solder material placed on the transmission portion is irradiated with the light beam while the printing mask is overlapped on the board, and the inspection object intensity of the reflected infrared ray having the specific wave number is detected. Therefore, because the in-line measurement is enabled, the labor hour necessary for the inspection can be suppressed because the in-line measurement is enabled, the diffuse reflection can be prevented because the irradiation surface can be formed flat, and the improvement of the measurement accuracy is achieved. Furthermore, at least one of the infrared absorbance of the specific wave number obtained based on the inspection object intensity in the solder material of the inspection object and the inspection object intensity is supplied as the measurement value. That is, from the standpoint of work health, the preferable measurement is performed by the infrared spectroscopy because the ultraviolet ray is not used during the measurement.

BRIEF DESCRIPTION OF THE DRAWINGS

Fig. 1 is a schematic view for explaining a configuration of a solder material inspecting device of the invention.

Fig. 2 is a functional block diagram showing a solder material inspecting device according to a first embodiment of the invention.

Fig. 3(a) is a conceptual view showing the solder material inspecting device according to the first embodiment of the invention.

Fig. 3(b) is a conceptual view showing the solder material inspecting device according to the first embodiment of the invention.

Fig. 4 is a sequence view showing a setting operation in the solder material inspecting device according to the first embodiment of the invention.

Fig. 5 is a sequence view showing a running operation in the solder material inspecting device according to the first embodiment of the invention.

Fig. 6 is a spectral chart showing infrared absorbance of cream solder of an inspection object and infrared absorbance of cream solder of a comparison object.

Fig. 7 is a table showing a component and a content (weight %) contained in the cream solder of the inspection object.

Fig. 8 is a chart showing an absorbance difference obtained by subtracting the infrared absorbance of the cream solder of the comparison object shown in Fig. 6 from the infrared absorbance of the cream solder of the inspection object shown in Fig. 6.

Fig. 9(a) is a chart showing an absorbance difference, which is obtained by subtracting the infrared absorbance of the cream solder of the comparison object from the infrared absorbance of cream solder of each inspection object, in each inspection object for plural inspection objects.

Fig. 9(b) is a table showing the number of print times, viscosity, and infrared absorbance at a predetermined number for plural inspection objects.

Fig. 10 is a chart showing an absorbance difference, which is obtained by subtracting the infrared absorbance of the cream solder of the comparison object from the infrared absorbance of cream solder of each inspection object, in each inspection object for plural inspection objects, and a chart for a wave number band of 520 cm$^{-1}$ to 700 cm$^{-1}$.

Fig. 11 is a chart showing an absorbance difference, which is obtained by subtracting the infrared absorbance of the cream solder of the comparison object from the infrared absorbance of cream solder of each inspection object, in each inspection object for plural inspection objects, and a chart for a wave number band of 1270 cm$^{-1}$ to 1420 cm$^{-1}$.

Fig. 12 is a chart showing an absorbance difference, which is obtained by subtracting the infrared absorbance of the cream solder of the comparison object from the infrared absorbance of cream solder of each inspection object, in each inspection object for plural inspection objects, and a chart for a wave number band of 1500 cm$^{-1}$ to 1650 cm$^{-1}$.

Fig. 13 is a chart showing an absorbance difference, which is obtained by subtracting the infrared absorbance of the cream solder of the comparison object from the infrared absorbance of cream solder of each inspection object, in each inspection object for plural inspection objects, and a chart for a wave number band of 1665 cm$^{-1}$ to 1725 cm$^{-1}$.

Fig. 14 is a functional block diagram showing a solder material inspecting device according to a second embodiment of the invention.

Fig. 15 is a sequence view showing a running operation in the solder material inspecting device according to the second embodiment of the invention.

Fig. 16 is a conceptual view showing signal extraction processing.

Fig. 17 is a conceptual view showing calculation processing of solder deterioration.

Fig. 18 is a sectional view explaining a cream solder print step of the cream solder.

Fig. 19 is a sectional view schematically showing a solder material inspecting device according to a third embodiment of the invention.

Fig. 20 is a functional block diagram showing the solder material inspecting device according to the third embodiment of the invention.

Fig. 21 is a sequence view of the solder material inspecting device according to the third embodiment of the invention.

Fig. 22 is a flowchart of the solder material inspecting device according to the third embodiment of the invention.

Fig. 23 is a sectional view schematically showing a solder material inspecting device according to a fourth embodiment of the invention.

Fig. 24 is a flowchart of the solder material inspecting device according to the fourth embodiment of the invention.

Fig. 25 is a sectional view schematically showing a solder material inspecting device according to a fifth embodiment of the invention.

Fig. 26 is a sectional view schematically showing a solder material inspecting device according to a sixth embodiment of the invention.

Fig. 27 is a sectional view schematically showing a solder material inspecting device according to a seventh embodiment of the invention.

Fig. 28 is a sectional view schematically showing a solder material inspecting device according to an eighth embodiment of the invention.

EXPLANATION OF LETTERS OR NUMERALS

| | |
|---|---|
| 1 | solder material inspecting device |
| 2 | board |
| 3 | cream solder |
| 10 | moving unit |
| 11 | X-stage |
| 12 | Y-stage |
| 20 | infrared spectroscopic measurement unit |
| 21 | light source |
| 22 | intensity detecting unit |
| 30 | storage unit |
| 40 | input unit |
| 50 | control unit |
| 60 | solder deterioration computing unit |
| 70 | output unit |
| 80 | signal extracting unit |
| 100 | solder material inspecting device |
| 110 | board |
| 111, 111A, and 111B | printing mask |
| 111 a | pattern hole |
| 1111 a | inspection hole |
| 111 b and 111 c | transmission portion |
| 111d | long portion |
| 1111b and 1112c | placement surface |
| 112 | cream solder |

| 113 | squeegee |
| 113A | first squeegee |
| 113B | second squeegee |
| 114 | detection unit |
| 115 | floodlighting unit |
| 116 | intensity detecting unit |
| 117 | processing unit |
| 118 | output unit |

BEST MODE FOR CARRYING OUT THE INVENTION

Embodiments of the invention will be described below with reference to the drawings. Although the cream solder is used as the solder material in the following embodiments, the invention is not limited to the cream solder.

[First Embodiment]

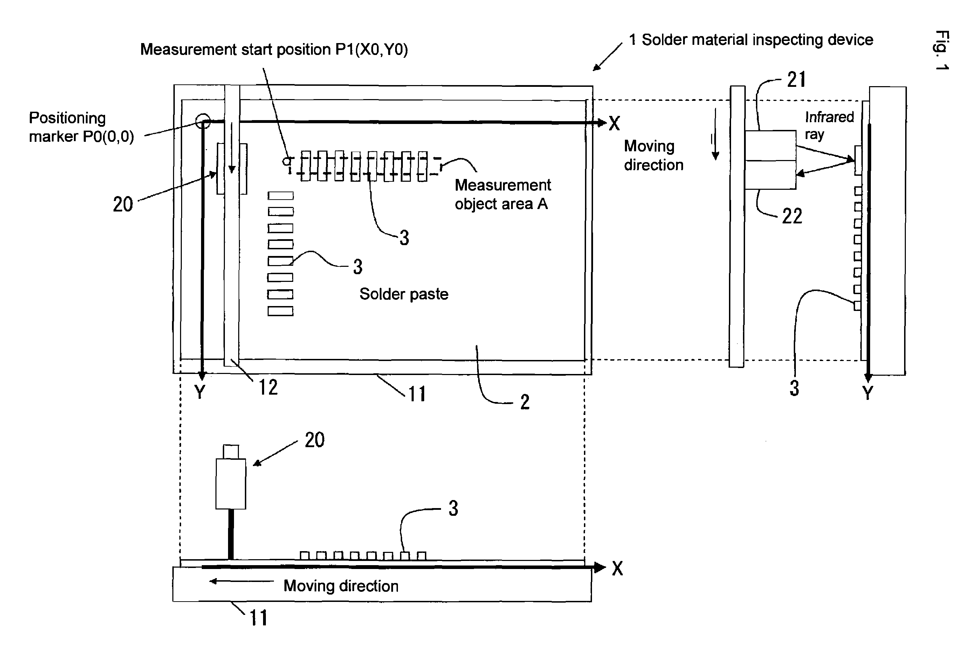

In a solder material inspecting device according to a first embodiment, after the cream solder is printed on the board by using the metal mask, the board is intermittently irradiated with the light beam to inspect the degree of deterioration of the solder material until the electronic component is mounted after the metal mask is detached from the board. The detailed description will be made with reference to Figs. 1 to 3.

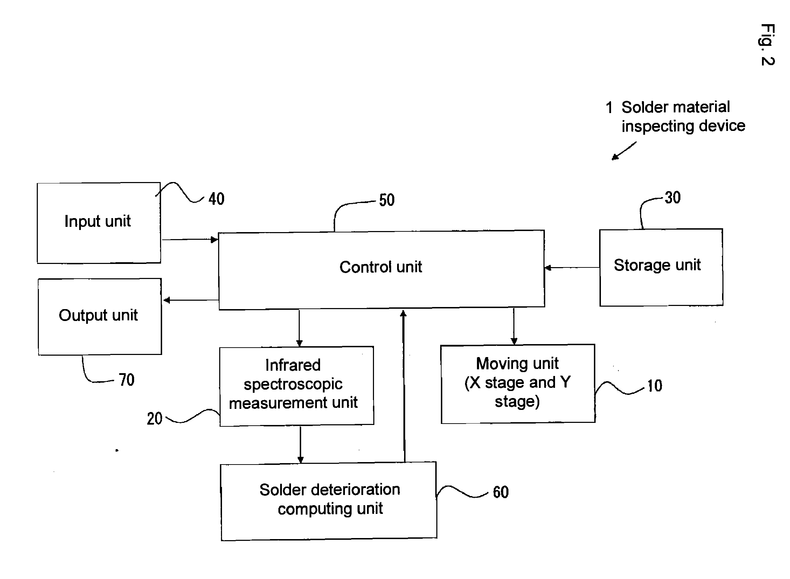

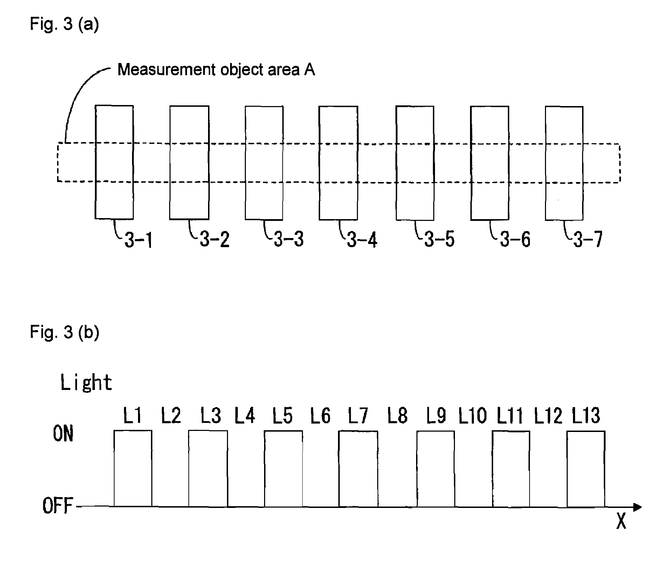

Fig. 1 is a schematic view for explaining a configuration of a solder material inspecting device of the invention, Fig. 2 is a block diagram thereof, and Fig. 3 is a conceptual view showing a light emission pattern of a light source.

A solder material inspecting device 1 of the invention includes a moving unit 10, an infrared spectroscopic measurement unit 20, a storage unit 30, an input unit 40, a control unit 50, a solder deterioration computing unit 60, and an output unit 70.

A moving unit 10 includes an X-stage 11 and a Y-stage 12. The X-stage 11 is configured to be able to proceed and recede in an X-axis direction of Fig. 2, a board 2 on which cream solder 3 is printed is positioned and placed based on a positioning marker origin (0,0). The Y-stage 12 is disposed above the X-stage 11, and the infrared spectroscopic measurement unit 20 is provided while hung on. The infrared spectroscopic measurement unit 20 is configured to be able to proceed and recede in a Y-axis direction of Fig. 2.

The infrared spectroscopic measurement unit 20 includes a light source 21 and an intensity detecting unit 22. The light source 21 is a lamp which emits the light beam to the cream marker 3 printed on the board 2. For example, a ceramic light source is used as the light source 21. In the first embodiment, only the cream solder 3 printed on the board 2 is irradiated with the light beam emitted from the light source 21, and the control unit 50 controls the light source 21 to intermittently emit the light beam by the later-mentioned manner. Another method of irradiating the cream solder 3 with the light beam emitted from the light source 21 is also adopted. For example, the light source 21 continuously emits the light beam, light shielding means formed by an opening and closing shutter (not shown) or the like which can shield the light beam emitted from the light source 21 is provided, the opening and closing of the opening and closing shutter are controlled by the control unit 50, and the cream solder 3 is irradiated with the light beam when the opening and closing shutter is opened, and the light beam is shielded when the opening and closing shutter is closed. Therefore, only the cream solder 3 is irradiated with the light beam.

A light emission pattern of the light source 21 will be described with reference to Fig. 3. Fig. 3(a) is an enlarged view showing a portion of a measurement object area A of Fig. 1, and Fig. 3(b) is a conceptual view showing an ON-OFF state of the light emission pattern of the light source 21. As shown in Fig. 3(a), the light source 21 sequentially scans the measurement object area A from cream solder 3-1 to cream solder 3-7. Then, when the light beam emitted from the light source 21 is located on the cream solder 3-1, the light source 21 becomes a state L1 (ON state) as shown in Fig. 3(b), and the cream solder 3 is irradiated with the light beam. On the other hand, the light beam emitted from the light source 21 is located between the cream solder 3-1 and the cream solder 3-2, the light source 21 becomes a state L2 (OFF state) as shown in Fig. 3(b), and the cream solder 3 is not irradiated with the light beam. The irradiation of the cream solder 3 with the light beam desirably is performed by the light source 21 before the electronic component is mounted on the board 2.

On the other hand, the intensity detecting unit 22 is formed by an infrared sensor. The intensity detecting unit 22 is configured to detect the intensity of the incident infrared ray, to generate an analog signal (light acceptance signal) indicating the intensity of the detected infrared ray, and to send the analog signal to the storage unit 30. A thermal type element such as a collector element and a thermopile or a quantum type element such as MCT (photoconductive cell, HgCdTe) can be listed as an example of the intensity detecting unit 22.

The storage unit 30 includes ROM (Read Only Memory) and RAM (Read Access Memory). CAD data of the board 2 or metal mask, the illumination light emission pattern, and the measurement object area A can be stored in the storage unit 30. The CAD data is used to specify the measurement object area A and to determine light emission timing of the light source 21. For example, a position coordinate and dimensions of an opening of the metal mask are fed into the CAD data as a reference point of a positioning mark P0 used in positioning the board 2 and the metal mask. Gerber data used in a CAD system including line and point coordinates as well as dimensions and shapes of the line and point may be stored in the storage unit 30.

The input unit 40 includes a keyboard, a mouse, or a touch panel. All the pieces of cream solder 3 printed on the board 2 is not inspected, but a person who inspects the degree of deterioration of the cream solder 3 can input the measurement object area A when arbitrarily selecting the measurement object area A to perform the measurement. For a method of inputting the measurement object area A, display means such as a display displays print positions of the cream solder 3 on the board 2, the range of the measurement object point is selected from the print positions by a drug manipulation of the mouse, and the print position is specified as the measurement object area A. Additionally, various methods are used as the method of selecting the measurement object area A. For example, the coordinate may be inputted by the keyboard.

The control unit 50 performs control of the entire of the solder material inspecting device 1 such as moving control of the moving unit 10, readout of information from the storage unit 30, and light emission control of the light source 21. The control unit 50 may be configured by either a hardware configuration such as a programmable controller or a software configuration such as a control program.

The solder deterioration computing unit 60 processes the analog signal sent from the intensity detecting unit 22 of the infrared spectroscopic measurement unit 20, and computes the degree of deterioration of the cream solder of the inspection object to send the computation result to the storage unit 30. For example, the solder deterioration computing unit 60 includes an A/D (Analog to Digital) converter which converts the analog signal into a digital signal and a computer which performs data processing based on the digital signal.

The output unit 70 is a display panel which displays an image based on image data sent from the control unit 50 or a communication device which supplies the measurement result to the outside.

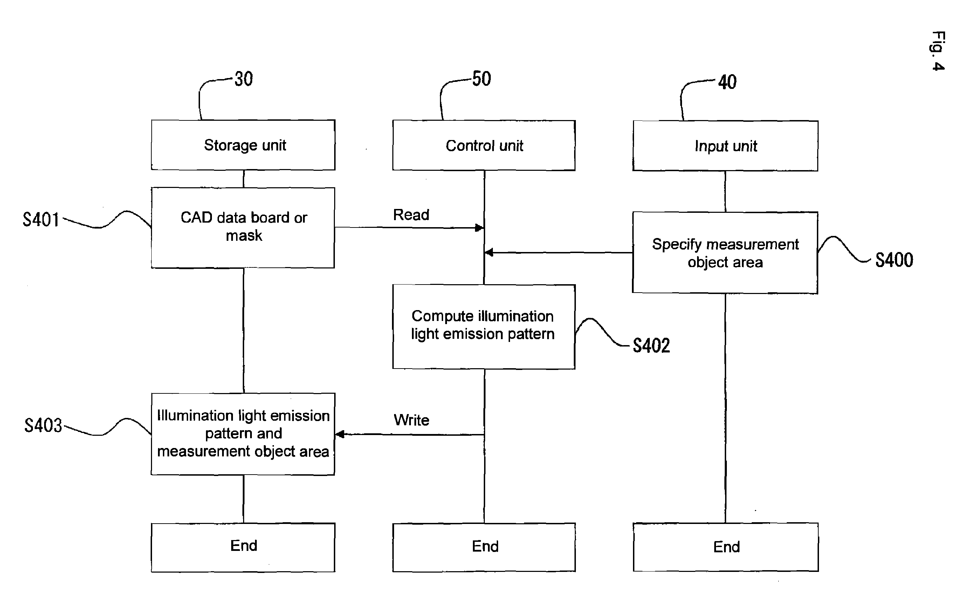

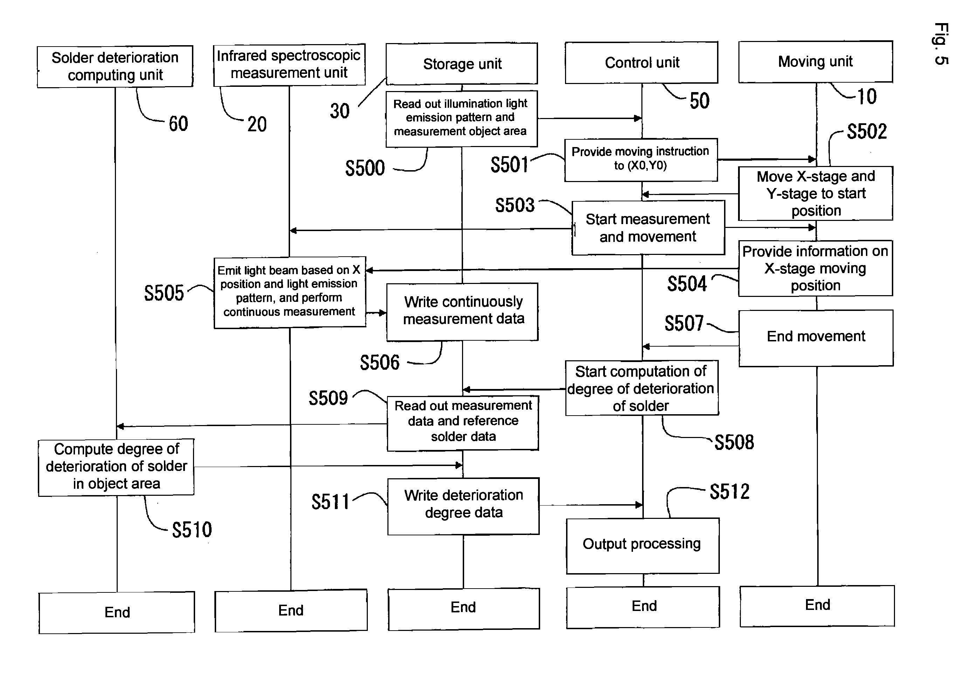

An operation of the solder material inspecting device of the first embodiment will be described below with reference to Figs. 4 and 5. Fig. 4 is a sequence view showing an operation for setting the light emission pattern of the light source and the measurement object area A in the solder material inspecting device of the invention, and Fig. 5 is a sequence view showing an operation for running the solder material inspecting device of the invention.

The operation for setting the light emission pattern of the light source and the measurement object area A will be described with reference to Fig. 4.

When an operator feeds the measurement object area A with the input unit 10 (S400), while information (hereinafter referred to as "area information") on the input measurement object area A is sent to the control unit 50 (S401), the control unit 50 reads the metal mask CAD data stored in the storage unit 30 (S401). The control unit 50 computes an illumination light emission pattern from the read CAD data and the fed area information (S402), and writes the illumination light emission pattern obtained by the computation and the area information in the storage unit 30 (S403), and the settings of the illumination light emission pattern and measurement object area A are ended. For example, the light emission pattern can be computed as follows. When the moving speeds of the X-stage 11 and Y-stage 12 of the moving unit 10 are kept constant, because the position and dimensions of the cream solder 3 in the measurement object area A are previously stored in the area information, the moving distance of the moving unit 10 can be recognized from the area information. Therefore, because a necessary time that the moving unit 10 is moved on each of the pieces of cream solder 3-1, 3-2, and ... can easily be computed from the moving speed and the moving distance, it is only necessary to the time necessary for the movement to a one-time irradiation time of the light source 21 which intermittently emits the light beam.

The operation for running the solder material inspecting device of the invention after the settings will be described below with reference to Fig. 5.

The control unit 50 reads out the illumination light emission pattern and area information which are written in the storage unit 30 by the setting operation (S500). For example, an inspection start button (not shown) is provided, and the operator manipulates the inspection start button to start the read out processing. Alternatively, when the setting processing is started, the running processing may be consecutively performed.

Then, the control unit 50 provides a moving instruction signal to the moving unit 10 to move the moving unit 10 to a measurement start position P1(X0,Y0) (S501), and the moving unit 10 which receives the moving instruction signal moves the X-stage 11 and Y-stage 12 such that the infrared spectroscopic measurement unit 20 is located on the measurement start position P1(X0,Y0) (S502). In the moving processing of the moving unit 10, a movement origin of the X-stage 11 of the moving unit 10 and a movement origin of the Y-stage 12 are previously assumed as a position where the infrared spectroscopic measurement unit 20 is disposed on the positioning marker P0(0,0), and the X-stage 11 and Y-stage 12 are moved to perform the positioning of the movement origins such that the infrared spectroscopic measurement unit 20 is located on the positioning marker P0(0,0). Because the area information includes the position where the positioning marker P0(0,0) is set to the origin, the dimensions, and the shape, the moving unit 10 is moved based on the area information. In positioning the movement origin, when a camera (not shown) or the like is provided on the Y-stage 12 so as to be able to recognize the positioning marker P0 on the board 2, a shift of the X-stage 11 on the board 2 may be corrected.

The control unit 50 provides a light emission instruction to the light source 21 based on the illumination light emission pattern read from the storage unit 30, and provides a moving instruction to the moving unit 10 such that the infrared spectroscopic measurement unit 20 is scanned on the measurement object area A (S503). When receiving the moving instruction, the moving unit 10 starts the movement on the measurement object area A (S504), and the light source 21 intermittently emits the light beam during the scanning based on the illumination light emission pattern, whereby only the cream solder 3 printed on the board 2 is irradiated with the light beam (S505). On the other hand, when the light source 21 emits the light beam to the cream solder 3, the infrared ray is reflected from the cream solder 3, and the infrared intensity (inspection object intensity) of the reflected infrared ray is detected by the intensity detecting unit 22 (S505), and the detected data is sent to the storage unit 30 and is continuously written in the storage unit 30 as measurement data (S506).

When the infrared spectroscopic measurement unit 20 ends the scanning (S507), the control unit 50 reads the measurement data (inspection object intensity) written in the storage unit 30 and previously stored comparison object intensity of the comparison object from the storage unit 30, and sends the read pieces of data to the solder deterioration computing unit 60 (S508 and S509).

Based on the pieces of data, the solder deterioration computing unit 60 computes the degree of deterioration of the cream solder 3 in the measurement object area A by the later-mentioned method (S510), and sends deterioration degree data indicating the computed degree of deterioration of the cream solder 3 to the storage unit 30. The sent deterioration degree data is written in the storage unit 30 (S511) while read out by the control unit 50. The sent deterioration degree data is then processed to be supplied from the output unit 70 (S512).

In the invention, the degree of deterioration of the cream solder is analyzed by the following method in which the infrared spectroscopy is utilized. The method will be described citing various embodiments.

When the cream solder is continuously used, or when the cream solder is continuously exposed to the external air, in the cream solder, the contained metal is oxidized to change the contained carboxylic acid into the carboxylate. That is, when the cream solder is continuously used, or when the cream solder is continuously exposed to the external air, in the cream solder, the contained metal oxide is increased, the contained carboxylic acid is decreased, and the contained carboxylate is increased.

There is generated a phenomenon, in which the increase in metal oxide enhances the degree of oxidation of the cream solder, the increase in carboxylate enhances the viscosity of the cream solder, and the decrease in carboxylic acid content lowers the reduction power of the cream solder. The phenomenon is called cream solder deterioration.

Accordingly, in the cream solder of the inspection object, when at least one of the metal oxide content, the carboxylic acid content, and the carboxylate content can be analyzed, at least one of the viscosity, degree of oxidation, and reduction power of the cream solder can be inspected, and therefore the degree of deterioration of the cream solder can be inspected.

On the other hand, it is known that each of the metal oxide, the carboxylic acid, and the carboxylate absorbs the infrared ray having the specific wave number band specified in each of the metal oxide, the carboxylic acid, and the carboxylate.

The analysis of the degree of deterioration of the cream solder can be realized by performing a combination of the following steps. The inspection object intensity of the infrared ray having the specific wave number, which is reflected from the cream solder of the inspection object, is detected by irradiating the cream solder of the inspection object with the light beam. Then, the comparison object intensity of the infrared ray having the specific wave number, which is reflected from the cream solder of the comparison object, is detected by irradiating the cream solder of the comparison object with the light beam. The degree of deterioration of the cream solder of the inspection object to the comparison object is relatively inspected based on the detected pieces of intensity. In the detection of the inspection object intensity and the detection of the comparison object intensity, the operation sequence may be reversed or concurrently performed. The comparison object intensity may be previously detected and stored in storage means (not shown).

Therefore, the inspection object intensity of the specific wave number of the infrared ray reflected from the cream solder of the inspection object and the comparison object intensity of the specific wave number of the infrared ray reflected from the cream solder of the comparison object can be detected.

At this point, as described above, each of the metal oxide, the carboxylic acid, and the carboxylate absorbs the infrared ray having the specific wave number band specified in each of the metal oxide, the carboxylic acid, and the carboxylate. Accordingly, an absorption amount of infrared ray having the specific wave number in the cream solder is changed depending on the metal oxide, carboxylic acid, and carboxylate contents in the cream solder, and the intensity of the infrared ray having the specific wave number which is reflected from the cream solder is changed.

Accordingly, at least one of the metal oxide content, the carboxylic acid content, and the carboxylate content in the cream solder of the comparison object can be relatively analyzed with respect to the cream solder of the comparison object based on the inspection object intensity and comparison object intensity detected by the method, so that the degree of deterioration of the cream solder of the inspection object can be relatively inspected with respect to the cream solder of the comparison object.

The inspection method includes (a) a procedure of obtaining a difference between the inspection object intensity and the comparison object intensity, (b) a procedure of obtaining a ratio between the inspection object intensity and the comparison object intensity, (c) a procedure of obtaining first infrared absorbance of the specific wave number in the cream solder of the inspection object from the inspection object intensity, obtaining second infrared absorbance of the specific wave number in the cream solder of the comparison object from the comparison object intensity, and obtaining a difference between the first infrared absorbance and the second infrared absorbance, and (d) a procedure of obtaining a ratio of the first infrared absorbance and the second infrared absorbance.

The difference or the ratio is a parameter indicating a degree of difference in infrared absorbance of the specific wave number between the cream solder of the comparison object and the cream solder of the inspection object. Therefore, differences in metal oxide, carboxylic acid, and carboxylate contents between the cream solder of the comparison object and the cream solder of the inspection object can be analyzed by obtaining the parameters, the viscosity, degree of oxidation, and reduction power of the cream solder of the inspection object to the cream solder of the comparison object can be relatively inspected, and the degree of deterioration (viscosity, degree of oxidation, and reduction power) of the cream solder of the inspection object can be relatively inspected.

In the inspection step, the difference or the ratio is not obtained, but a person who implements the first embodiment of the invention simply compares the detected pieces of intensity or the detected absorbances, whereby the person can make a relative determination of the degree of deterioration of the cream solder of the inspection object to the comparison object.

Different pieces of cream solder may be used as the inspection object and the comparison object, or the same cream solder may be used as the inspection object and the comparison object.

The phrase "the same cream solder is used" shall mean that, for example, cream solder a in a new state is used as the comparison object while the cream solder a in the used state (used in the board print step) is used as the inspection object. Alternatively, cream solder b having 100 print times in the board print step is used as the comparison object while the cream solder b having 200 print times is used as the inspection object.

One embodiment of the method of analyzing the degree of deterioration of the cream solder will be described below.

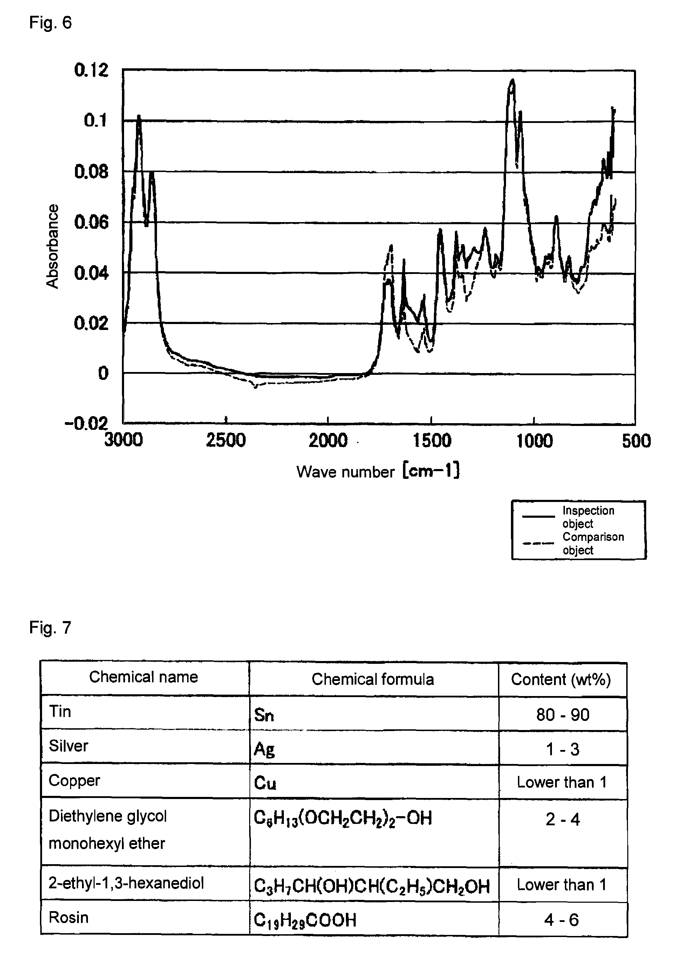

The cream solder which constitutes the inspection object in the first embodiment will be described. In the first embodiment, cream solder containing components shown in Fig. 7 was used for the inspection. As shown in Fig. 7, the cream solder of the first embodiment contains 80 to 90% of tin, 1 to 3% of silver, 1 % or less of copper, 2 to 4% of diethylene glycol monohexyl ether, 1% or less of 2-ethyl-1,3-hexanediol, and 4 to 6% of rosin.

The cream solder mainly contains the metal such as tin (Sn) and zinc (Pb). In the cream solder of the first embodiment, tin is used as the metal as shown in Fig. 7. In the cream solder of the first embodiment, as shown in Fig. 7, rosin ($C_{19}H_{29}COOH$) is used as the carboxylic acid which is the main component exhibiting reduction power in the cream solder.

In the first embodiment, the cream solder in the new state shown in Fig. 7 was used as the comparison object, and the cream solder already used in the board print step was used as the inspection object. Hereinafter, the cream solder of the comparison object may be simply referred to as "comparison object" and the cream solder of the inspection object may be simply referred to as "inspection object".

The comparison object and the inspection object are irradiated with the infrared ray having the same intensity, the intensity (comparison object intensity) of a band ranging from 500 cm$^{-1}$ to 3000 cm$^{-1}$ was detected in the infrared ray reflected from the comparison object, and the intensity (inspection object intensity) of the band ranging from 500 cm$^{-1}$ to 3000 cm$^{-1}$ was detected in the infrared ray reflected from the inspection object.

Furthermore, in the first embodiment, the absorbance (second infrared absorbance) of the infrared ray of the comparison object and the absorbance (first infrared absorbance) of the infrared ray of the inspection object of the infrared ray were computed for each wave number. The absorbance can be obtained by computing the following equations (1) and (2) in each wave number:

$$\text{absorbance of infrared ray of comparison object (absorbance}$$

$$\text{corresponding to wave number h) } A' = -\log(A/BL) \quad (1)$$

absorbance of infrared ray of inspection object (absorbance corresponding

to wave number h) B' = -log(B/BL)     (2)

wherein BL is a blank value corresponding to the wave number h (intensity at the wave number h of the emitted infrared ray), A is intensity in the wave number h of the infrared ray reflected from the comparison object, and B is intensity in the wave number h of the infrared ray reflected from the inspection object.

Fig. 6 shows a spectral chart showing the computed absorbance. In Fig. 6, a horizontal axis indicates a wave number of an infrared ray, and vertical axis indicates infrared absorbance.

As shown in Fig. 6, it is observed that the comparison object differs from the inspection object in the infrared absorbance.

Then, the study is made on the difference. Specifically, a difference was computed by an equation (11) for the absorbances A' and B' corresponding to the wave numbers obtained in the equations (1) and (2).

absorbance difference = B' - A'                    (11)

Hereinafter the difference is referred to as "absorbance difference". That is, the absorbance difference is obtained by subtracting the infrared absorbance of the comparison object from the infrared absorbance of the inspection object, and the absorbance difference indicates the difference between the infrared absorbance of the inspection object and the infrared absorbance of the comparison object.

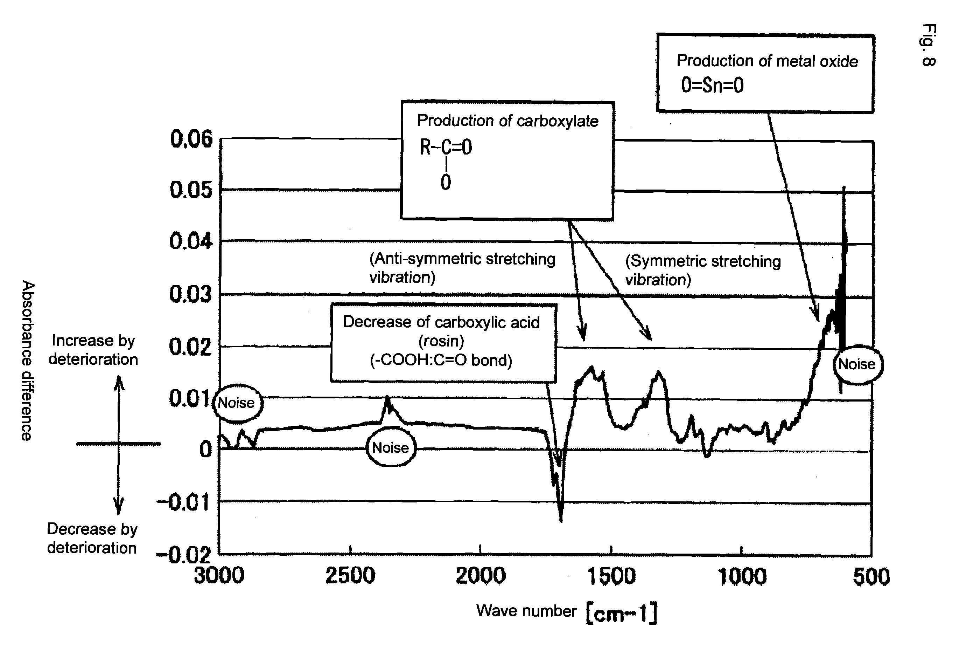

Fig. 8 is a chart showing a relationship between the wave number of the infrared ray and the absorbance difference corresponding to the wave number. That is, the chart of Fig. 8 shows the absorbance difference obtained by subtracting the absorbance of the comparison object of Fig. 6 from the absorbance of the inspection object of Fig. 6.

As can be seen from Fig. 8, the comparison object and the inspection object differ largely from each other in the absorbances near 600 $cm^{-1}$, near 1300 $cm^{-1}$, near 1600 $cm^{-1}$, and near 1700 $cm^{-1}$.

Specifically, it is observed that the infrared absorbance of the inspection object is higher than the infrared absorbance of the comparison object near 600 $cm^{-1}$, near 1300 $cm^{-1}$, and in 1600 $cm^{-1}$. It is also observed that the infrared absorbance of the inspection object is lower than the infrared absorbance of the comparison object near 1700 $cm^{-1}$.

At this point, in the infrared spectral chart, it is known that the absorption observed near 600 $cm^{-1}$ is caused by vibration of an oxygen-metal bond in the metal oxide. It is also known that the absorption observed near 1300 $cm^{-1}$ is caused by symmetric stretching vibration of the carboxylate and the absorption observed near 1600 $cm^{-1}$ is caused by anti-symmetric stretching vibration of the carboxylate. It is further known that the absorption observed near 1700 $cm^{-1}$ indicates absorption caused by stretching vibration of a double bond in the carboxylic acid.

Accordingly, because the inspection object is higher than the comparison object in the infrared absorbance near 600 $cm^{-1}$, it is apparent that the large amount of metal oxide is contained in the inspection object compared with the comparison object and the inspection object is higher than the comparison object in the degree of oxidation.

Because the inspection object is higher than the comparison object in the infrared absorbance near 1300 $cm^{-1}$ and near 1600 $cm^{-1}$, it is apparent that the large amount of carboxylate is contained in the inspection object compared with the comparison object and the inspection object is higher than the comparison object in the viscosity.

Because the inspection object is lower than the comparison object in the infrared absorbance near 1700 $cm^{-1}$, it is apparent that the inspection object is lower than the comparison object in the carboxylic acid and the inspection object is lower than the comparison object in the reduction power.

Thus, in the first embodiment, the absorbance (first infrared absorbance) of the infrared ray in the cream solder of the inspection object and the absorbance (second infrared absorbance) of the infrared ray in the cream solder of the comparison object are obtained for each wave number of the infrared spectrum from the intensity (inspection object intensity) of the infrared ray reflected from the cream solder of the inspection object and the intensity (comparison object intensity) of the infrared ray reflected from the cream solder of the comparison object.

Then, the absorbance difference is obtained for each wave number of the infrared spectrum by subtracting the absorbance of the cream solder of the comparison object from the absorbance of the cream solder of the inspection object. At this point, when the absorbance difference is referred to near 600 $cm^{-1}$, near 1300 $cm^{-1}$, near 1600 $cm^{-1}$, and near 1700 $cm^{-1}$, the metal oxide content, carboxylic acid content, and carboxylate content contained in the cream solder of the inspection object can be relatively understood with respect to the comparison object.

The degree of oxidation of the cream solder of the inspection object can be relatively understood from the metal oxide content, the reduction power of the cream solder of the inspection object can be relatively understood from the carboxylic acid content, and the viscosity of the cream solder of the inspection object can be relatively understood from the carboxylate content.

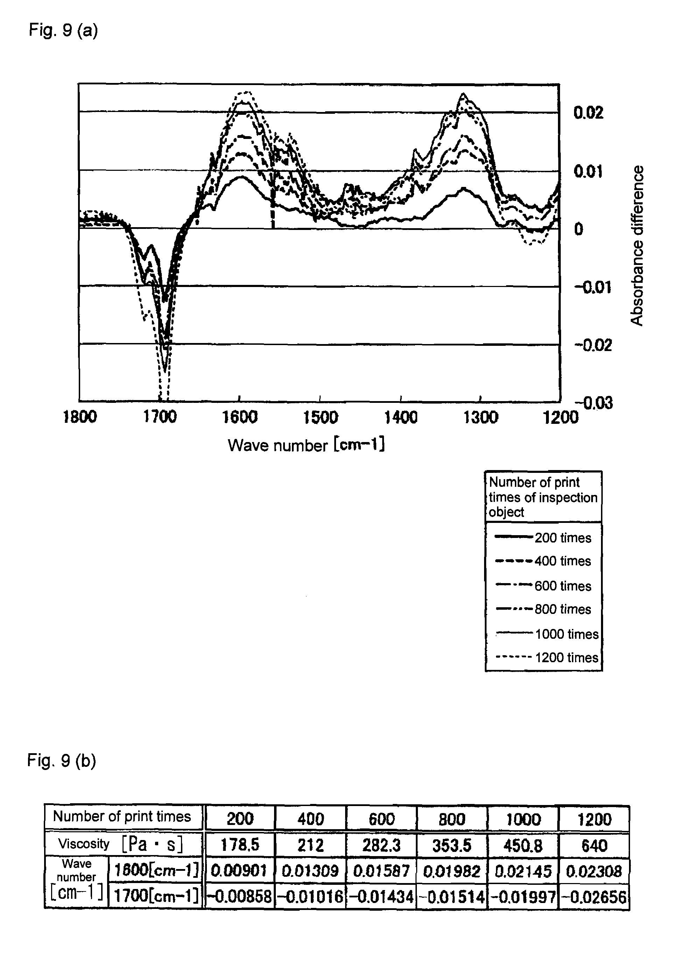

Fig. 9(a) shows analysis results performed by the method of the first embodiment, in which the cream solder in the new state is set to the comparison object while the pieces of cream solder having the 200, 400, 600, 800, 1000, and 1200 print times in the board print step are set to the inspection object.

Fig. 9(a) is a chart showing a relationship between the wave number of the infrared ray and the absorbance difference corresponding to each wave number in each inspection object. The absorbance difference is obtained by subtracting the absorbance of the cream solder of the comparison object from the absorbance of the cream solder of the inspection object. Here, a horizontal axis indicates a wave number of an infrared ray, and vertical axis indicates an absorbance difference which is the difference between the absorbance of the cream solder of the comparison object and the absorbance of the cream solder of the inspection object.

As can be seen from Fig. 9(a), as the number of print times of the cream solder is increased, the absorbances are increased near 1300 $cm^{-1}$ and near 1600 cm-1, and the absorbance is decreased near 1700 $cm^{-1}$. Therefore, in the cream solder, it is apparent that, as the number of print times is increased, the carboxylic acid is decreased while the carboxylate is increased. From the result of the increase in carboxylate, the analysis shows that the viscosity of the cream solder is increased as the number of print times is increased.

When the viscosity was actually measured for each inspection object, it is confirmed that a positive correlation holds between the number of print times of the cream solder and the viscosity of the cream solder as shown in Fig. 9 (b). It is also confirmed that the positive correlation holds between the absorbance of the infrared ray near 1600 $cm^{-1}$ in the cream solder and the viscosity of the cream solder and the negative correlation holds between the absorbance of the infrared ray near 1700 $cm^{-1}$ in the cream solder and the viscosity of the cream solder. The reasons why the correlations hold are that, as the number of print times of the cream solder is increased, the carboxylic acid contained in the cream solder is decreased to reduce the absorbance of the infrared ray near 1700 $cm^{-1}$, the carboxylate contained in the cream solder is increased to enlarge the absorbance of the infrared ray near 1600 $cm^{-1}$, and the viscosity is increased with increasing carboxylate.

According to the first embodiment, infrared absorbance of the cream solder of the inspection object and the infrared absorbance of the cream solder of the comparison object are computed. However, even if the absorbances are not computed, the metal oxide content, carboxylic acid content, and carboxylate content contained in the cream solder of the inspection object can be relatively understood. Specifically, the intensity of the infrared ray reflected from cream solder of the inspection object and the intensity of the infrared ray reflected from the cream solder of the comparison object are detected for each wave number ranging from 500 $cm^{-1}$ to 3000 $cm^{-1}$. In each wave number, computation expressed by an equation (21) is performed to each pieces of detected intensity:

$$\text{intensity difference} = B - A \qquad (21)$$

A: intensity of infrared ray reflected from comparison object
B: intensity of infrared ray reflected from inspection object

As used herein, the term "intensity difference" shall mean one in which the intensity of the infrared ray detected in the comparison object is subtracted from the intensity of the infrared ray detected in the inspection object, which is a difference between the intensity of the infrared ray detected in the inspection object and the intensity of the infrared ray detected in the comparison object.

At this point, when the intensity difference is referred to near 600 $cm^{-1}$, near 1300 $cm^{-1}$, near 1600 $cm^{-1}$, and near 1700 $cm^{-1}$, differences in infrared absorption amount of the metal oxide, carboxylic acid, and carboxylate between the inspection object and the comparison object can be understood. Therefore, the metal oxide content, carboxylic acid content, and carboxylate content contained in the cream solder of the inspection object can be relatively understood with respect to the comparison object.

The difference in infrared absorbance between the comparison object and the inspection object can be understood not by the absorbance difference or intensity difference but by the ratio of absorbances or the ratio of the pieces of intensity, and the metal oxide content, carboxylic acid content, and carboxylate content contained in the cream solder of the inspection object can be relatively understood.

For example, an intensity ratio which is a ratio of the intensity of the infrared ray detected in the inspection object and the intensity of the infrared ray detected in the comparison object may be obtained in each wave number by the following computation:

$$\text{intensity ratio} = B/A \qquad\qquad (31)$$

For example, an absorbance ratio which is a ratio of the absorbance of the infrared ray in the inspection object and the absorbance of the infrared ray in the comparison object may be obtained in each wave number by the following computation:

$$\text{absorbance ratio} = B'/A \qquad\qquad (41)$$

The method of computing the absorbance is similar to those of the equations (1) and (2).

A': absorbance of infrared ray of comparison object
B': absorbance of infrared ray of inspection object

According to the first embodiment, for the cream solder of the comparison object and the cream solder of the inspection object, the intensity of the infrared ray is detected in each wave number in the range of 500 cm$^{-1}$ to 3000 cm$^{-1}$, and the absorbance of the infrared ray and the absorbance difference, the absorbance ratio, the intensity difference, or the intensity ratio are computed. Alternatively, the intensity is detected only for the infrared ray having the specific wave number, and then the absorbance, absorbance difference, and intensity ratio of the specific wave number or the intensity difference and the intensity ratio may be computed. As used herein, the specific wave number shall mean a wave number in which at least one piece of infrared absorption of the metal oxide, the carboxylic acid, and the carboxylate is recognized. In the first embodiment, the specific wave number is at least one of the 600 cm$^{-1}$, 1300 cm$^{-1}$, 1600 cm$^{-1}$, and 1700 cm$^{-1}$.

The intensity of the light beam emitted from the floodlighting unit 15 fluctuates. Even if the same floodlighting unit 15 is used to irradiates the comparison object and the inspection object with the infrared ray, when the comparison object and the inspection object are irradiated with the infrared ray at different timing, the infrared ray with which the comparison object is irradiated and the infrared ray with which the comparison object is irradiated differ slightly from each other in the intensity. The difference may have an adverse effect on the detected intensity of the infrared ray reflected from the cream solder.

Therefore, preferably, correction is performed when the intensity difference, the intensity ratio, the absorbance difference, and the absorbance ratio are obtained in the specific wave number. A procedure of obtaining a correction intensity difference in which the intensity difference is corrected, a correction intensity ratio in which the intensity ratio is corrected, a correction absorbance difference in which the absorbance difference is corrected, and a correction absorbance ratio in which the absorbance ratio is corrected will be described below.

A reference wave number (for example, 2929 cm$^{-1}$) is set in the cream solder inspecting device 1. The reference wave number is located out of the wave number bands in which the pieces of infrared absorption of the metal oxide, carboxylic acid, and carboxylate are observed, and is a wave number in which the infrared ray reflected from the comparison object differs from the infrared ray reflected from the inspection object in the intensity.

The intensity of the reference wave number in the infrared ray reflected from the comparison object and the intensity of the reference wave number in the infrared ray reflected from the inspection object are detected. The intensity of the specific wave number in the infrared ray reflected from the comparison object and the intensity of the specific wave number in the infrared ray reflected from the inspection object are also detected.

It is assumed that Aref is intensity (fourth intensity, comparison object reference intensity) of the reference wave number in the infrared ray reflected from the comparison object, Bref is intensity (third intensity, inspection object reference intensity) of the reference wave number in the infrared ray reflected from the inspection object, Atar is intensity (comparison object intensity) of the specific wave number in the infrared ray reflected from the comparison object, and Btar is intensity (inspection object intensity) of the specific wave number in the infrared ray reflected from the inspection object.

It is also assumed that A'ref is infrared absorbance (fourth infrared absorbance) of the reference wave number in the comparison object, B'ref is infrared absorbance (third infrared absorbance) of the reference wave number in the inspection object, A'tar is infrared absorbance (second infrared absorbance) of the specific wave number in the comparison object, and B'tar is infrared absorbance (first infrared absorbance) of the specific wave number in the inspection object.

The absorbances are computed by the techniques similar to those of equations (1) and (2). That is, the absorbances are obtained by the following equations:

$$A'ref = -\log(Aref/BLref) \qquad (61)$$

$$B'ref = -\log(Bref/BLref) \qquad (62)$$

$$A'tar = -\log(Atar/BLtar) \qquad (63)$$

$$B'tar = -\log(Btar/BLtar) \qquad (64)$$

wherein BLref is intensity corresponding to the reference wave number in the infrared ray with which the comparison object is irradiated, and BLtar is intensity corresponding to the specific wave number in the infrared ray with which the inspection object is irradiated.

The correction intensity difference, the correction intensity ratio, the correction absorbance difference, and the correction absorbance ratio can be obtained from the following equations:

$$\text{correction intensity difference} = (Btar - Bref) - (Atar - Aref) \qquad (71)$$

$$\text{correction intensity ratio} = (Btar - Bref)/(Atar - Aref) \qquad (72)$$

$$\text{correction absorbance difference} = (B'tar - B'ref) - (A'tar - A'ref) \qquad (73)$$

$$\text{correction absorbance ratio} = (B'tar - B'ref)/(A'tar - A'rcf) \qquad (74)$$

Therefore, even if the infrared ray with which the comparison object is irradiated differs slightly from the infrared ray with which the inspection object is irradiated in the intensity, because the intensity of the reference wave number corresponding to the difference is subtracted for each intensity and each absorbance, the correction intensity difference, the correction intensity ratio, the correction absorbance difference, and the correction absorbance ratio can be obtained while the difference is substantially eliminated.

The correction intensity difference, the correction intensity ratio, the correction absorbance difference, and the correction absorbance ratio can be obtained from the following equations:

$$\text{correction intensity difference} = (Btar \times Aref/Bref) - Atar \qquad (75)$$

$$\text{correction intensity ratio} = (Btar \times Aref/Bref)/Atar \qquad (76)$$

$$\text{correction absorbance difference} = (B'tar \times A'ref/B'ref) - A'tar \qquad (77)$$

$$\text{correction absorbance ratio} = (\text{B'tar} \times \text{A'ref/B'ref})/\text{A'tar} \qquad (78)$$

In the method, Aref/Bref or A'ref/B'ref is used as a correcting coefficient of the difference.

Each value of the specific wave numbers (600 $cm^{-1}$, 1300 $cm^{-1}$, 1600 $cm^{-1}$, and 1700 $cm^{-1}$) can be changed. That is, the specific wave number is not limited to 600 $cm^{-1}$, 1300 $cm^{-1}$, 1600 $cm^{-1}$, and 1700 $cm^{-1}$, but an effective range can be set as the specific wave number. The description will specifically be made on this point.

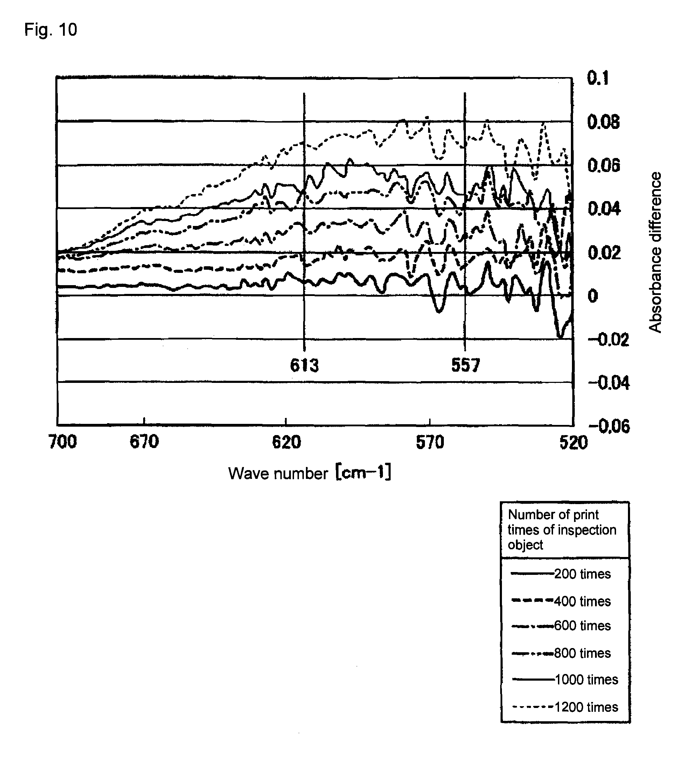

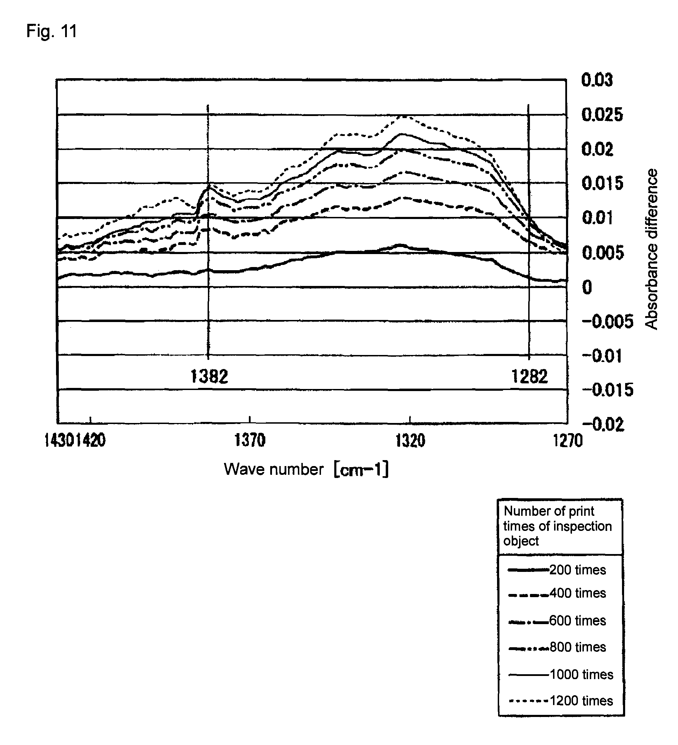

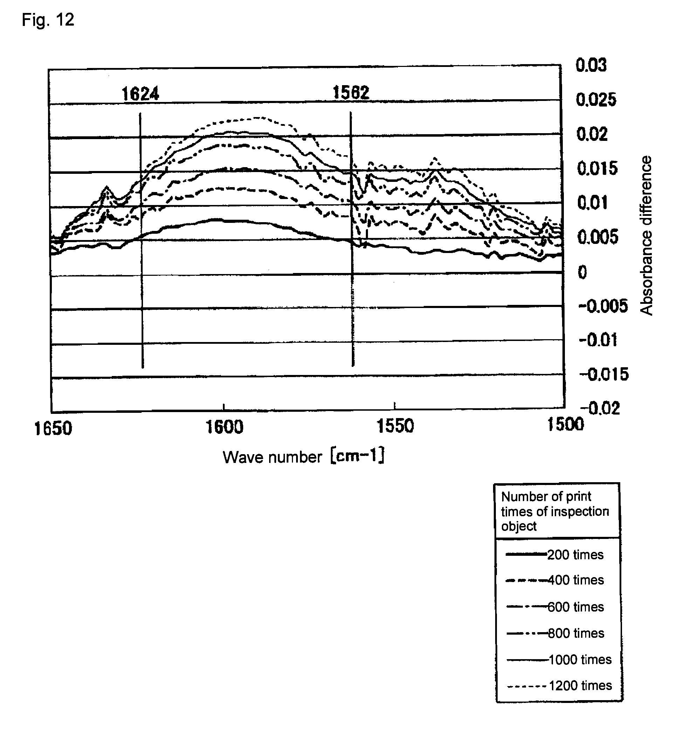

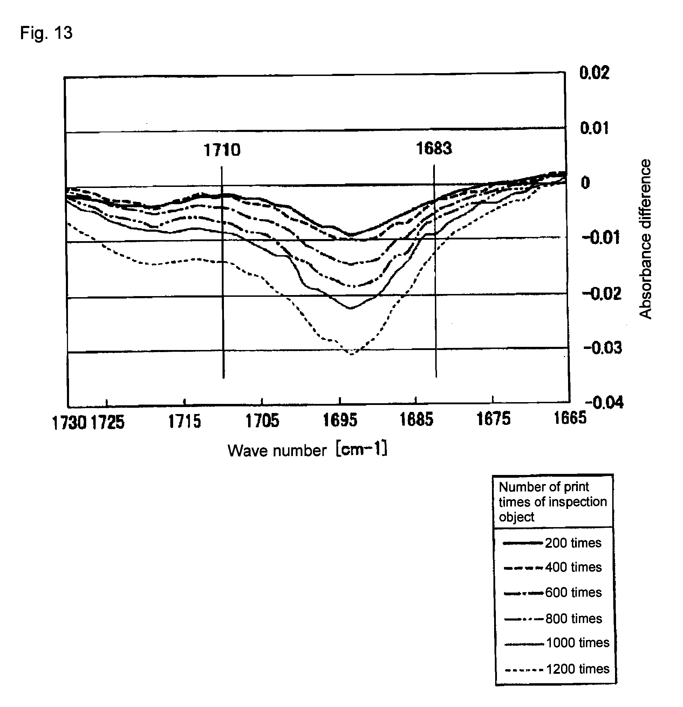

Similarly to the analysis in Fig. 9, the cream solder in the new state was set to the comparison object while the pieces of cream solder having the 200, 400, 600, 800, 1000, and 1200 print times in the board print step were set to the inspection object, and the absorbance difference was obtained for each inspection object by the method shown in the first embodiment. Figs. 5 to 8 show the results. Fig. 10 shows the absorbance difference for the wave number band of 520 $cm^{-1}$ to 700 $cm^{-1}$, Fig. 11 shows the absorbance difference for the wave number band of 1270 $cm^{-1}$ to 1430 $cm^{-1}$, Fig. 12 shows the absorbance difference for the wave number band of 1500 $cm^{-1}$ to 1650 $cm^{-1}$, and Fig. 13 shows the absorbance difference for the wave number band of 1665 $cm^{-1}$ to 1730 $cm^{-1}$.

An absorption peak of the metal oxide (tin dioxide) contained in the cream solder is detected near 600 $cm^{-1}$. As shown in Fig. 10, the difference in absorbance difference can be distinguished among the inspection objects by focusing on the range of 520 $cm^{-1}$ to 700 $cm^{-1}$, and the difference in absorbance difference of the inspection objects can be observed further significantly by focusing on the range of 557 $cm^{-1}$ to 613 $cm^{-1}$. Accordingly, the metal oxide content of each inspection object can be analyzed when at least one of the wave numbers between 520 $cm^{-1}$ and 700 $cm^{-1}$ is set to the specific wave number.

An absorption peak of the symmetric stretching vibration of the carboxylate is detected near 1300 $cm^{-1}$ (strictly, at 1323 $cm^{-1}$). As shown in Fig. 11, the difference in absorbance difference can be distinguished among the inspection objects by focusing on the range of 1270 $cm^{-1}$ to 1430 $cm^{-1}$, and the difference in absorbance difference of the inspection objects can be observed further significantly by focusing on the range of 1282 $cm^{-1}$ to 1382 $cm^{-1}$. Accordingly, the carboxylate content of each inspection object can be analyzed when at least one of the wave numbers between 1270 $cm^{-1}$ to 1430 $cm^{-1}$ is set to the focused wave number.

An absorption peak of the anti-symmetric stretching vibration of the carboxylate is detected near 1600 $cm^{-1}$ (strictly, at 1590 $cm^{-1}$). As shown in Fig. 12, the difference in absorbance difference can be distinguished among the inspection objects by focusing on the range of 1500 $cm^{-1}$ to 1650 $cm^{-1}$, and the difference in absorbance difference of the inspection objects can be observed further significantly by focusing on the range of 1562 $cm^{-1}$ to 1624 $cm^{-1}$. Accordingly, the carboxylate content of each inspection object can be analyzed when at least one of the wave numbers between 1500 $cm^{-1}$ to 1650 $cm^{-1}$ is set to the focused wave number.

An absorption peak of the carbon-oxygen double bond of the carboxylic acid is detected near 1700 $cm^{-1}$. As shown in Fig. 13, the difference in absorbance difference can be distinguished among the inspection objects by focusing on the range of 1665 $cm^{-1}$ to 1730 $cm^{-1}$, and the difference in absorbance difference of the inspection objects can be observed further significantly by focusing on the range of 1683 $cm^{-1}$ to 1710 $cm^{-1}$. Accordingly, the carboxylic acid content of each inspection object can be analyzed when at least one of the wave numbers between 1665 $cm^{-1}$ to 1730 $cm^{-1}$ is set to the focused wave number.

[Second Embodiment]

A solder material inspecting device according to a second embodiment is similar to that of the first embodiment in that the degree of deterioration of the cream solder is inspected before the reflow after the print is ended and the metal mask is detached, and in that the infrared spectroscopy is utilized. However, roughly the second embodiment differs from the first embodiment in that only the cream solder printed on the board is not irradiated with the light beam unlike the first embodiment, but the board, the cream solder, and optionally the electronic component mounted on the board are irradiated with the light beam to detect the intensity of the infrared ray which is the reflected light beam, and only the intensity (inspection object intensity) of the cream solder is extracted from the pieces of intensity. Only a portion different from that of the first embodiment will be described in detail, and the description of the same portion as the first embodiment is omitted.

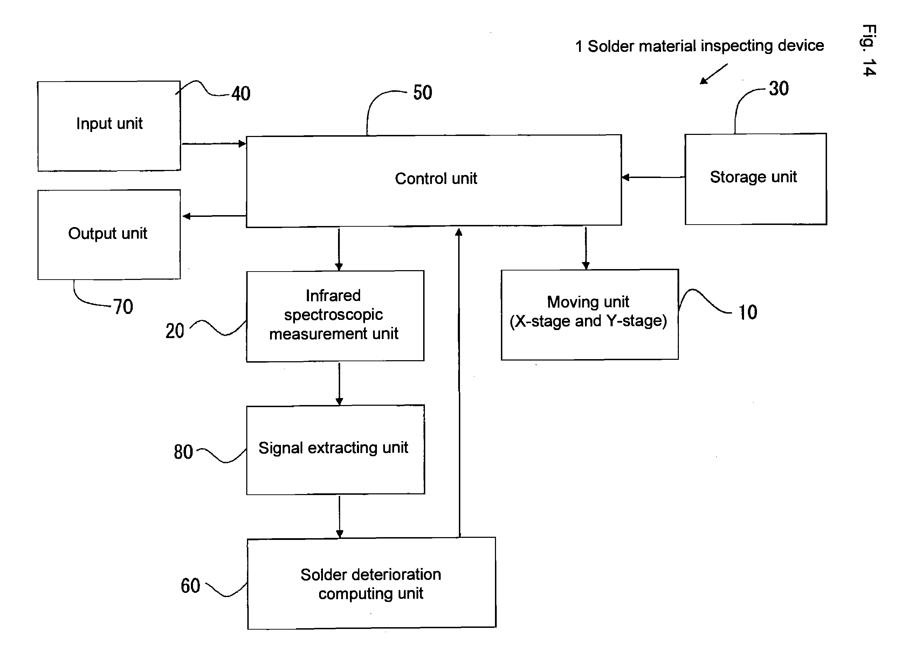

A configuration of solder material inspecting device of the second embodiment will be described below with reference to Figs. 1 and 14. Fig. 14 is a functional block diagram showing the solder material inspecting device of the second embodiment of the invention.

Similarly to the first embodiment, the schematic configuration of the solder material inspecting device 1 of the second embodiment is shown in Fig. 1. However, as shown in Fig. 14, it differs from that of the first embodiment in that a signal extracting unit 80 which is intensity extraction means is further included.

In the configuration of the signal extracting unit 80, the board 2 on which the cream solder 3 is printed is irradiated with the light beam while the light beam is scanned, and the inspection object intensity of the infrared ray having the specific wave number which is the reflected light beam detected only from the cream solder 3 is extracted from the measurement intensity which is the intensity of the reflected infrared ray having the specific wave number. For example, computation means such as CPU executes a program stored in storage means such as ROM and RAM, and the signal extracting unit 80 can be realized by controlling input means such as a keyboard, output means such as a display, and communication means such as an interface circuit. The specific extraction processing is described later.

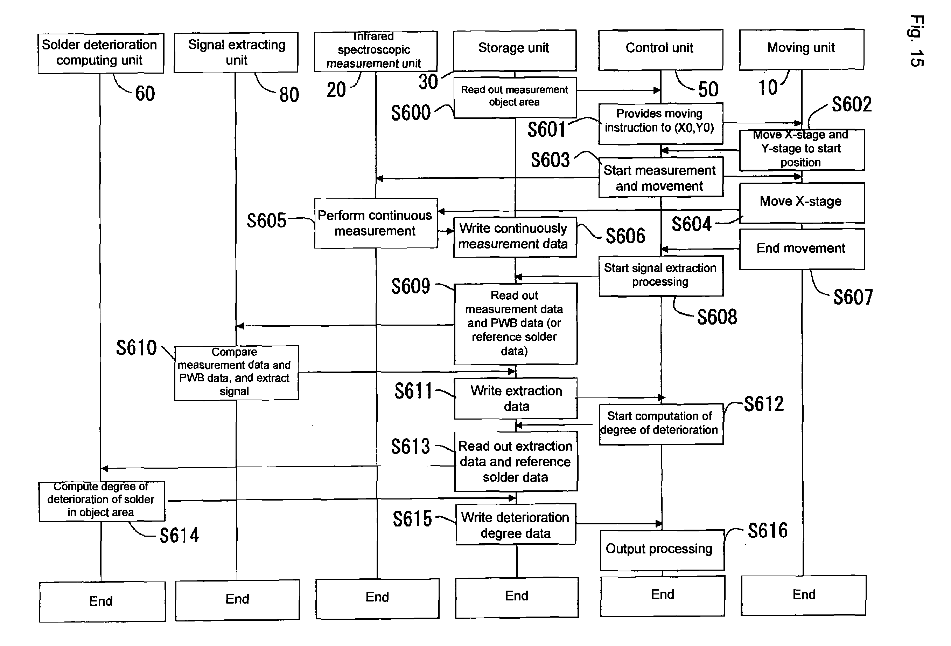

The running operation of the solder material inspecting device of the second embodiment will be described below with reference to Fig. 15. Fig. 15 is a sequence view of the running operation.

When a person who performs the inspection feeds the measurement object area A with the input unit 40, similarly to the first embodiment, the area information is written in the storage unit 30. Then, the control unit 50 reads out the area information from the storage unit 30 and sends the moving instruction signal to the moving unit 10, and the moving unit 10 which receives the moving instruction signal moves the X-stage 11 and the Y-stage 12 to move the infrared spectroscopic measurement unit 20 to the measurement start position P1 (X0,Y0) (S600 to S603). The methods similar to those of the first embodiment can be applied to these operations.

The control unit 50 provides the light emission instruction to the light source 21, and provides the moving instruction to the moving unit 10 such that the infrared spectroscopic measurement unit 20 scans the measurement object area A (S603). Then, the infrared spectroscopic measurement unit 20 scans the measurement object area A while continuously emitting the light beam (S604). On the other hand, when the light source 21 emits the light beam to the measurement object area A, the intensity detecting unit 22 detects the intensity of the infrared ray which is as the reflected light beam (S605), the detected data is sent to the storage unit 30 and continuously written as the measurement data in the storage unit 30 (S606), and the moving unit 10 ends the movement when the scanning is ended in the measurement object area A (S607). The second embodiment differs from the first embodiment in that the light source 21 continuously emits the light beam not only to the cream solder 3 in the measurement object area A but also to the board 2. Even if the electronic component is mounted in the measurement object area A, only the intensity (inspection object intensity) of the infrared ray having the specific wave number which is the light beam reflected from the cream solder 3 can be extracted depending on the later-mentioned signal extraction processing.

Then, the control unit 50 acts as intensity detection means for extracting the inspection object intensity, and starts the signal extraction processing. The signal extraction processing will be described below.

[First Example of Signal Extraction Processing]

The board is irradiated with the light beam, the intensity of the infrared ray having the specific wave number which is reflected from the board is detected, and the intensity is previously stored as the board intensity in the storage unit 30. This is because reference data is obtained. The reference data indicates what pattern is exhibited by the intensity of the reflected infrared ray having the specific wave number when the board is irradiated with the light beam. The inspection object intensity is extracted by computing a difference between the measurement intensity and the board intensity stored in the storage unit 30.

[Second Example of Signal Extraction Processing]

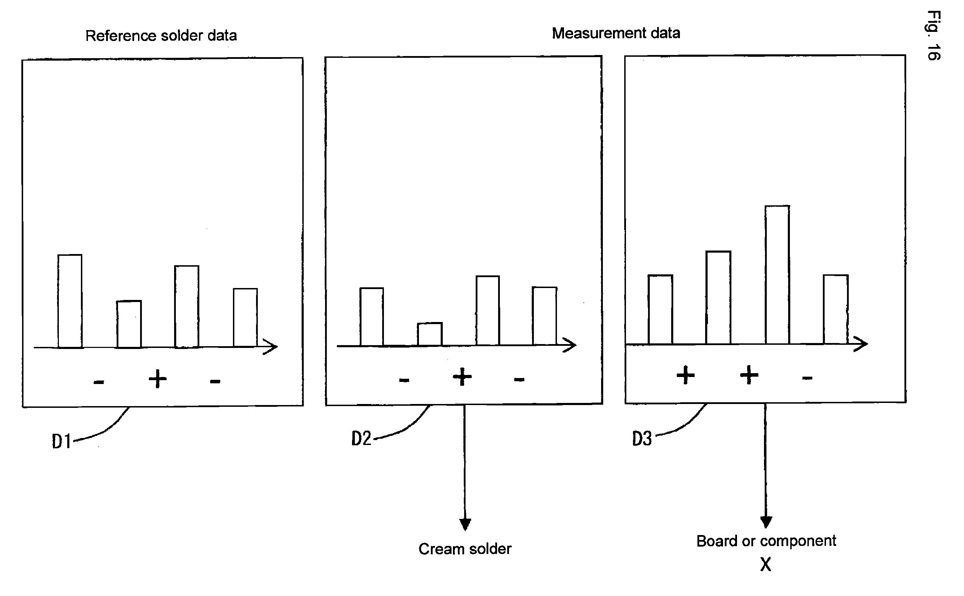

The cream solder is irradiated with the light beam, the intensity of the infrared ray having the specific wave number which is reflected from the cream solder is detected, and the intensity is previously stored as solder intensity in the storage unit 30. This is because reference data is obtained. The reference data indicates what pattern is exhibited by the intensity of the reflected infrared ray having the specific wave number when the cream solder is irradiated with the light beam. The inspection object intensity is extracted by comparing an increasing and decreasing pattern of a signal of the solder intensity stored in the storage unit 30 to an increasing and decreasing pattern of a signal of the measurement intensity. Fig. 16 conceptually shows the extraction method. The letter D1 designates solder intensity which becomes the reference data, the letter D2 designates a portion corresponding to the cream solder in the measurement intensity, and the letter D3 designates a portion corresponding to the board or component in the measurement intensity. One element of a bar graph is a value which is normalized by light beam intensity of the specific wave number or light beam intensity of the reference wave number. In this case, the pieces of light beam intensity of the specific wave numbers, 1665 cm-1 to 1730 cm-1 (a1), 1500cm-1 to 1650 cm-1 (a2), 1270 cm-1 to 1430 cm-1 (a3), and 520 cm-1 to 700 cm-1 (a4) are divided by the light beam intensity of the reference wave number 1100 cm-1 to 1200 cm-1 (b) to perform the normalization. The normalized values become a1/b, a2/b, a3/b, and a4/b from the left side of Fig. 16. As shown in D1 of Fig. 16, in the reference solder data, the increasing and decreasing pattern of the signal is changed in -, +, and -. In D2 of the measurement data, the increasing and decreasing pattern of the signal is also changed in -, +, and -. Accordingly, it is recognized that D2 is a signal indicating the solder intensity. Although the new cream solder may be used as the cream solder used to obtain the reference data, preferably, the comparison object intensity can be utilized when the cream solder of the comparison object is used as the cream solder. According to this method, the inspection object intensity can be extracted even if the electronic component or the like exists on the board, and the inspection can be performed immediately before the reflow, so that the measurement accuracy can further be improved. Additionally, the inspection object intensity can be extracted with no influence of the deterioration of the board.

[Third Example of Signal Extraction Processing]

The light source 21 emits the light beam to the board 2 on which the cream solder 3 is printed, and the intensity detecting unit 22 detects all the pieces of measurement intensity which are the intensity of the infrared ray reflected from the board 2. All the pieces of measurement intensity include not only the intensity of the infrared ray reflected from the cream solder 3 but also the intensity of the infrared ray reflected from the board 2. Then, the signal extracting unit 80 compares a predetermined threshold and the intensity of the infrared ray having the reference wave number which is the wave number except for the specific wave number in all the pieces of measurement intensity detected by the intensity detecting unit 22. When the intensity is not more than the threshold, while the intensity is set to the solder intensity, the inspection object intensity of the infrared ray having the specific wave number is extracted from the solder intensity. Because the solder material reflection brightness is extremely lower than the board reflection brightness, the inspection object intensity can be extracted by the method. The intensity of the light beam having the reference wave number which is reflected from the cream solder and the intensity of the light beam having the reference wave number which is reflected from the board are measured, the threshold is previously obtained as a value which can distinguish between the intensity of the light beam reflected from the cream solder and the intensity of the light beam reflected from the board, and may previously be set in the storage unit 30.

Alternatively, for another method of extracting the inspection object intensity, the summation of the pieces of intensity of the reflected light beams having the specific wave numbers are obtained instead of the intensity of the reflected light beam having the reference wave number, the threshold is similarly obtained by an experiment or the like, and the intensity of the light beam reflected from the cream solder may similarly be extracted by the threshold. An average value of all the pieces of measurement intensity is utilized instead of the intensity of the reflected light beam having the reference wave number, the threshold is similarly obtained by the experiment or the like, and the intensity of the light beam reflected from the cream solder may similarly be extracted by the threshold.

When the signal extraction processing is ended, the extracted extraction data (inspection object intensity) is sent to the storage unit 30, and the extraction data is written in the storage unit 30 (S611). The pieces of processing (S612 to S616) subsequent to S611 are similar to those in S508 to S512 shown in Fig. 5.

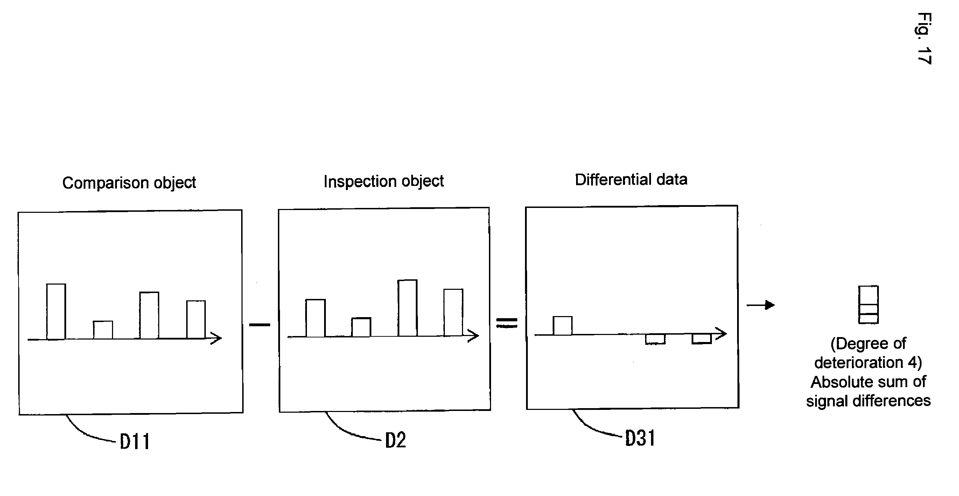

The solder deterioration computing processing may be performed as shown in Fig. 17. Fig. 17 shows a conceptual view when the degree of deterioration of the solder is obtained from a difference (D31) between the inspection object intensity (D11) of the cream solder of the comparison object and the comparison object intensity (D2) of the cream solder of the inspection object, and Fig. 17 shows the difference D31 obtained from D11-D2 as the absolute summation of each signal difference. An element of each bar graph becomes a value which is normalized in the above-described manner. Thus, when the difference is shown as the absolute summation, the degree of deterioration of the cream solder can be recognized at a glance.

[Third Embodiment]

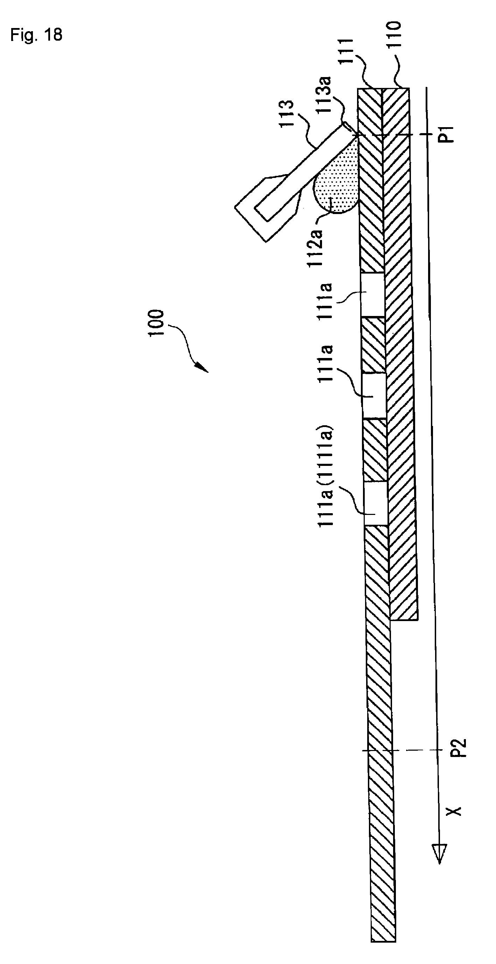

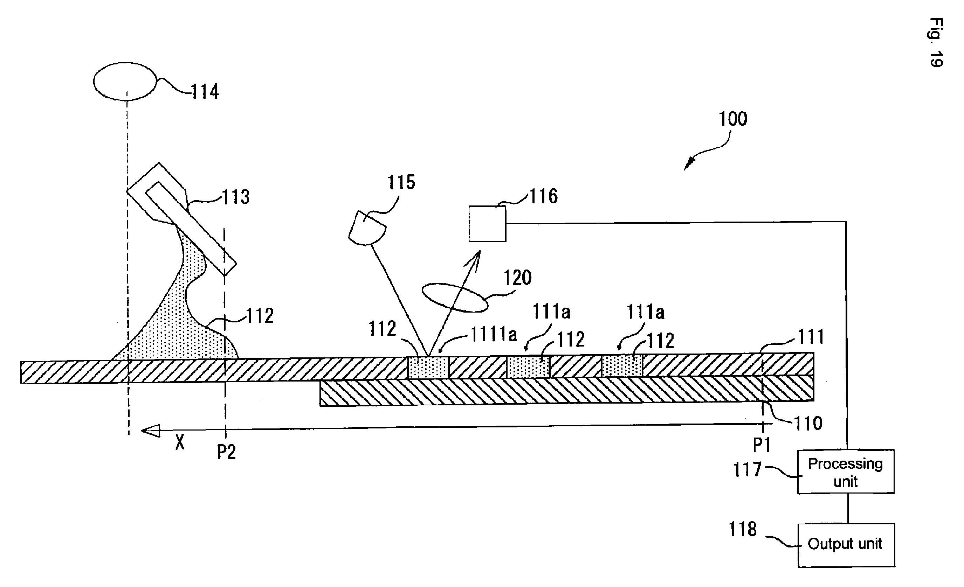

In a solder material inspecting device according to a third embodiment, after the cream solder is printed on the board by using a mask, the board is irradiated with the light beam while the mask is attached to the board, and the degree of deterioration of the solder material is inspected. A structure of the solder material inspecting device of the third embodiment will be described with reference to Figs. 18 and 19. The solder material inspecting device of the third embodiment includes not only an inspecting mechanism for inspecting the degree of deterioration of the cream solder but also a printing mechanism for printing the cream solder. However, the invention is not limited to the configuration of the third embodiment.

The printing mechanism will be described with reference to Fig. 18. Fig. 18 is a sectional view explaining a print step, and Fig. 18 shows a print start state.

A printing mask 111 in which pattern holes 111 a, 111 a, and ... are made is disposed in a board 110 in which a wiring pattern (not shown) is formed while being overlapped on the board 110. At this point, the pattern holes 111 a, 111 a, and ... are disposed at positions where pieces of cream solder 112 are printed on the wiring pattern.

Then, the cream solder 112 is supplied onto the side of a print start position P1 on the surface of the printing mask 111, a front end portion 113a of a squeegee 113 is caused to abut on the surface of the printing mask 111, the squeegee 113 is slid from the print start position P1 to a print end position P2. The front end portion 113a of a squeegee 113 is made of a material such as rubber, a resin, and a metal, and the squeegee 113 is slid while inclined toward a print direction X of Fig. 18.

The cream solder 112 is moved while rolled on the printing mask 111 by sliding of the squeegee 113, the pattern holes 111 a, 111 a, and ... are sequentially filled with the cream solder 112 from the pattern hole 111 a located on the side of the print start position P1, and the cream solder 112 is printed on the board 110 through the pattern holes 111 a, 111 a, and ....

During the print, the surface cream solder 112 with which the pattern holes 111 a, 111 a, and ... are filled is flattened by the squeegee 113.

In the third embodiment, the printing mechanism is utilized to fill the pattern holes 111 a, 111 a, and ... with the cream solder 112, and an arbitrary pattern hole 111 a in the pattern holes 111 a, 111 a, and ... is set to an inspection hole 1111a. Then, the surface of the cream solder 112 in the inspection hole 1111 a is irradiated with the light beam to analyze the degree of deterioration.

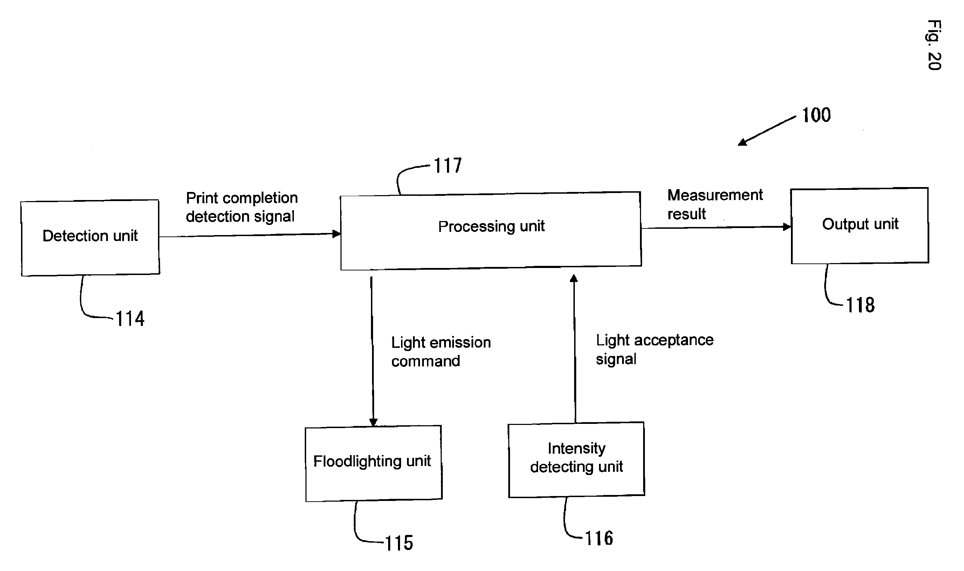

A structure of the inspecting mechanism in the solder material inspecting device of the third embodiment will be described below with reference to Figs. 19 and 20. Hereinafter, the inspecting method performed by the inspecting mechanism of the third embodiment may be referred to as noncontact measurement method.

Fig. 19 is a sectional view schematically showing the solder material inspecting device of the third embodiment, and in particular, a sectional view schematically showing the inspecting mechanism for analyzing the degree of deterioration of the cream solder. Fig. 20 is a functional block diagram showing the inspecting mechanism.

A solder material inspecting device 100 includes a detection unit 114, a floodlighting unit 115, an intensity detecting unit 116, a processing unit 117, and an output unit 118. The output unit 118 can supply the inspection result.

The detection unit 114 is formed by a photoelectric sensor, an ultrasonic sensor, an infrared sensor, and the like. The detection unit 114 detects the print end of the squeegee 113, and is disposed at the print end position P2 of the squeegee 113. When the squeegee 113 is moved to shield the light beam emitted from the detection unit 114, the detection unit 114 detects the print end and sends a print completion detection signal indicating print completion to the processing unit 117.

The floodlighting unit 115 is a lamp which emits the light beam to the inspection hole 1111a in the pattern holes 111a. For example, a ceramic light source is used as the floodlighting unit 115. When the processing unit 117 sends the light emission command signal of emitting the light beam to the floodlighting unit 115, the floodlighting unit 115 emits the light beam to the inspection hole 1111a. Thus, the floodlighting unit 115 is configured so as to receive the light emission command signal to emit the light beam, saving of the power consumption and the suppression of the heat generation are achieved in comparison with the configuration in which the light beam is always emitted.

The intensity detecting unit 116 is formed by the infrared sensor. The intensity detecting unit 116 detects the intensity of the incident infrared ray, generates an analog signal (light acceptance signal) indicating the intensity of the detected infrared ray, and sends the analog signal to the processing unit 117. An infrared sensor including a thermal type element such as a collector element and a thermopile as well as a quantum type element such as MCT (photoconductive cell, HgCdTe) can be listed as an example of the intensity detecting unit 116. The intensity detecting unit 117 is provided so as to be located on an optical axis of the infrared ray which is as the light beam reflected from the cream solder 112 or at a focal point of a collective mirror.

In the third embodiment, a bandpass filter 120 is provided between the intensity detecting unit 116 and the printing mask 111. The bandpass filter 120 is an optical filter disposed on the optical axis of the intensity detecting unit 116, and transmits only the infrared ray having the specific wave number. The specific wave number is a wave number at which at least one of pieces of infrared absorption of the metal oxide, carboxylic acid, and carboxylate is observed.

The processing unit 117 processes the analog signal sent from the intensity detecting unit 116, and sends the measurement result to the output unit 118. For example, the processing unit 117 includes an A/D (Analog to Digital) converter which converts the analog signal into the digital signal and a computer which performs the data processing based on the digital signal.

For example, computation means such as CPU executes a program stored in storage means such as ROM and RAM, and the processing unit 117 can be realized by controlling input means such as a keyboard, output means such as a display, and communication means such as an interface circuit. Accordingly, the computer including these means reads a recording medium in which the program is recorded, and the computer executes the program, whereby various functions and various pieces of processing of the processing unit 117 can be realized. The various functions and various pieces of processing can be realized on any computer by recording the program in a removable recording medium.

The recording medium may be a memory (not shown), for example, a program medium such as ROM for the purpose of processing with a microcomputer. Alternatively, a program read device is provided as an external storage device (not shown), and the recording medium may be inserted into the program read device to be able to read the program medium.

In any case, desirably the microprocessor accesses the stored program to execute the program. The program is read out, the read out program is downloaded in a program storage area of the microcomputer, and it is assumed that the program is previously stored in a main body device.

The program medium is a recording medium which is formed separately from the main body. Examples of the program medium include a tape system such as magnetic tape and cassette tape, a disk system such as a magnetic disk including a flexible disk and a hard disk, and CD/MO/MD/DVD disks, a card system such as an IC card (including a memory card), and a recording medium fixedly bearing the program including a semiconductor memory such as a mask ROM, EPROM (Erasable Programmable Read Only Memory), EEPROM (Electrically Erasable Programmable Read Only Memory), and a flash ROM.

When the system configuration can be connected to a communication network including the Internet, preferably, the recording medium bearing the program in a floating manner is used such that the program is downloaded through the communication network.

In the case where the program is downloaded from the communication network, preferably, a downloading program is previously stored in a main body apparatus or installed from another recording medium.

The output unit 118 is a display panel which displays the measurement result based on the measurement result sent from the processing unit 117 or a communication device which supplies the measurement result to the outside.

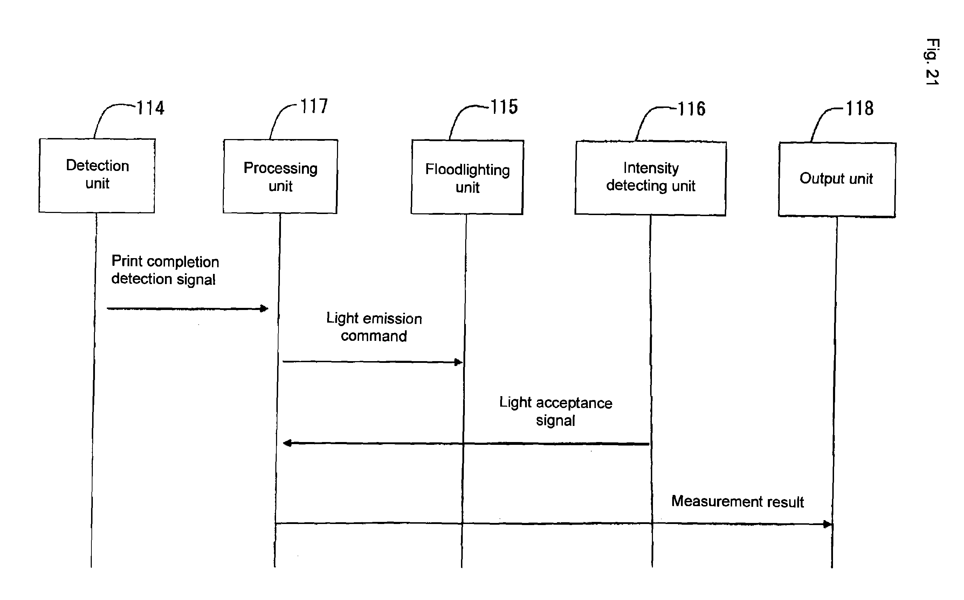

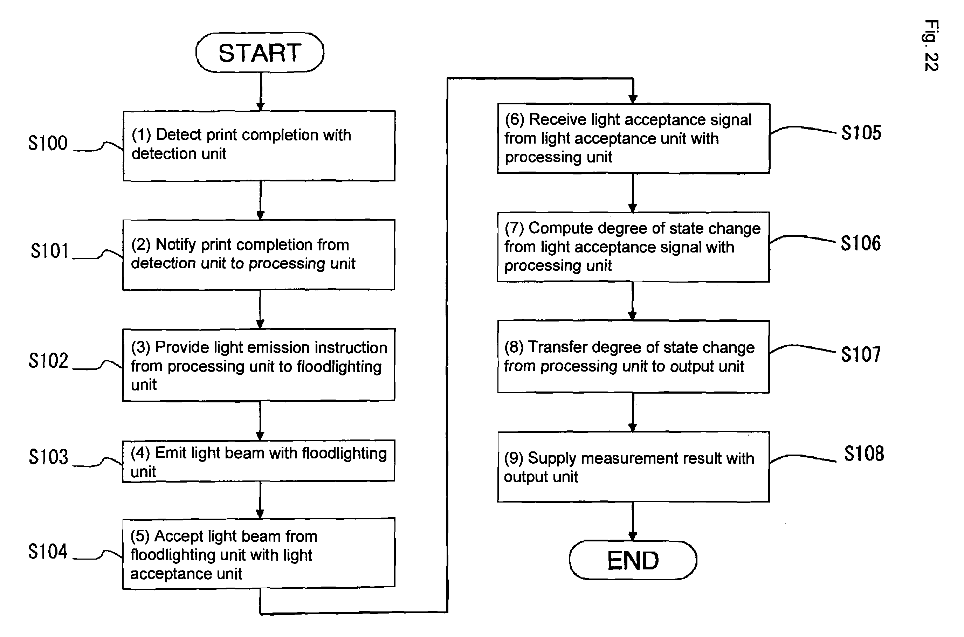

An operation of the solder material inspecting device will be described below with reference to Figs. 21 and 22. Fig. 21 is a sequence view, and Fig. 22 is a flowchart.

When the squeegee 113 is slid and located at the print end position P2, the squeegee 113 shields the infrared ray emitted from the detection unit 114. The detection unit 114 detects the print completion (S100), and sends the print completion detection signal to the processing unit 117 (S101). The processing unit 117 sends the light emission command signal to the floodlighting unit 115 when receiving the print completion detection signal (S102). The floodlighting unit 115 which receives the light emission command signal emits the light beam to the cream solder 112 with which the inspection hole 1111a is filled (S103). When the floodlighting unit 115 emits the light beam to the cream solder 112, the intensity detecting unit 116 accepts the infrared ray which is the reflected light beam through the bandpass filter 120 (S104), and sends the light acceptance signal to the processing unit 117 (S105). The processing unit 117 receives the light acceptance signal, and computes a degree of state change from the light acceptance signal (S106). Then, the processing unit 117 sends the computed degree of state change to the output unit 118. The output unit 118 receives the degree of state change to supply the measurement result (S108).

The degree of state change shall mean the degree of deterioration of the cream solder of the inspection object with respect to the cream solder of the comparison object. In the invention, using the infrared spectroscopy, the processing unit 117 analyzes the degree of deterioration of the cream solder. Because the infrared spectroscopy is identical to that of the first embodiment, the description is omitted.

[Fourth Embodiment]

A solder material inspecting device according to a fourth embodiment is similar to that of the third embodiment in that the print end is detected to inspect the degree of deterioration of the cream solder by the infrared spectroscopy. Therefore, only a portion different from that of the third embodiment will be described, and the descriptions of the similar configuration and operation are omitted.

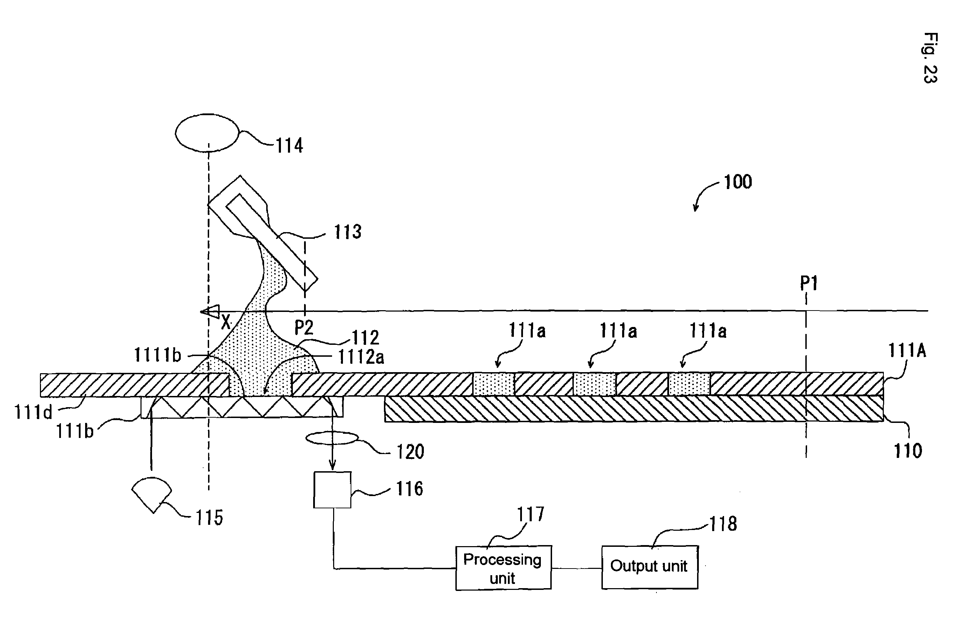

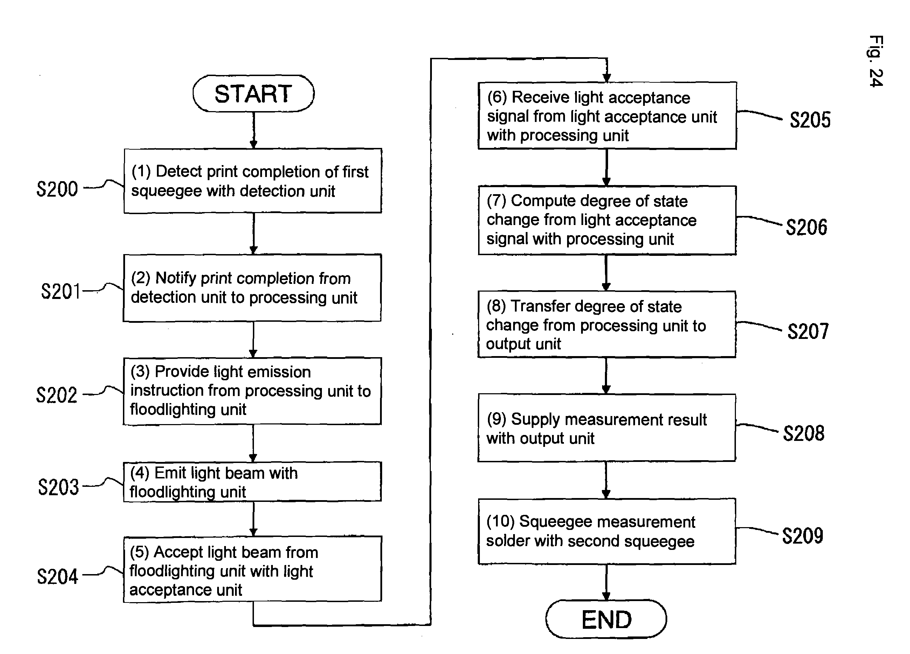

The solder material inspecting device of the fourth embodiment will be described below with reference to Figs. 23 and 24. Fig. 23 is a sectional view schematically showing the solder material inspecting device of the fourth embodiment, and Fig. 24 is a flowchart thereof.

In the solder material inspecting device 100 of the fourth embodiment, the cream solder 112 is printed on the board 110 by the method shown in Fig. 18.

The solder material inspecting device 100 of the fourth embodiment differs from that of the third embodiment in that the inspection hole 1111 a is not filled with the cream solder 112 of the inspection object, but the cream solder 112 is placed on a transmission portion 111 b, the cream solder 112 placed on the transmission portion 111 b is irradiated with the light beam from a backside of a printing mask 111A to inspect the degree of deterioration of the cream solder 112. The solder material inspecting device 100 of the fourth embodiment will be described in detail.

The print end position side of the printing mask 111 A is formed longer rather than the board 110 when the printing mask 111A is overlapped on the board 110 (portion of the printing mask 111A formed longer than the board 110 in Fig. 23 is referred to as "long portion 111 d"), and a hole 1112a is made in the long portion 111d. A bottom side of the hole 1112a is closed by a flat-shape transmission portion 111 b fixed to the backside of the printing mask 111 A, and the transmission portion 111 b constitutes a bottom portion of the hole 1112a (hereinafter the bottom portion is referred to as "placement surface 1111b").

The squeegee 113 is slid on the surface of the printing mask 111A having the configuration while the printing mask 111A is overlapped on the board 110, thereby performing the print. When the print is ended, the squeegee 113 is lifted upward at the print end position P2. The transmission portion 111b is formed immediately below the lifted squeegee 113. Therefore, when the squeegee 113 ends the print, the cream solder 112 is placed on the transmission portion 111 b.

The transmission portion 111 b is configured such that the light beam emitted from the floodlighting unit 115 is totally reflected from the placement surface 1111 b. For example, the transmission portion 111 b is formed by a prism made of ZnSe, Ge, or the like.

The floodlighting unit 115 is disposed on the backside of the printing mask 111A, and the transmission portion 111b is irradiated with the light beam from the backside. Therefore, the floodlighting unit 115 is configured that the cream solder 112 of the inspection object placed on the transmission portion 111 b is irradiated with the light beam from the backside.

The intensity detecting unit 116 is also disposed on the backside of the printing mask 111A so as to be able to detect the inspection object intensity of the infrared ray which is as the light beam reflected from the cream solder 112 of the inspection object.

The plural reflections are generated in the transmission portion 111 b, and the placement surface 1111 b is irradiated with the light beam in which the plural reflections are generated. When the floodlighting unit 115 and the intensity detecting unit 116 are disposed so as to detect the inspection object intensity of the infrared ray which is as the reflected light beam, the improvement of the measurement accuracy is further achieved.

Other configurations are similar to those of the noncontact measurement method, and the operations until the measurement result is displayed after the print end is detected are similar to those of Figs. 21 and 22. Therefore, the description is neglected.

As described above, in the fourth embodiment, the cream solder of the inspection object placed on the placement surface of the transmission portion is irradiated with the light beam from the backside to detect the inspection object intensity of the infrared ray which is as the reflected light beam. Therefore, it is not necessary to particularly flatten the irradiation surface of the cream solder, and the improvement of the measurement accuracy is further achieved.

[Fifth Embodiment]

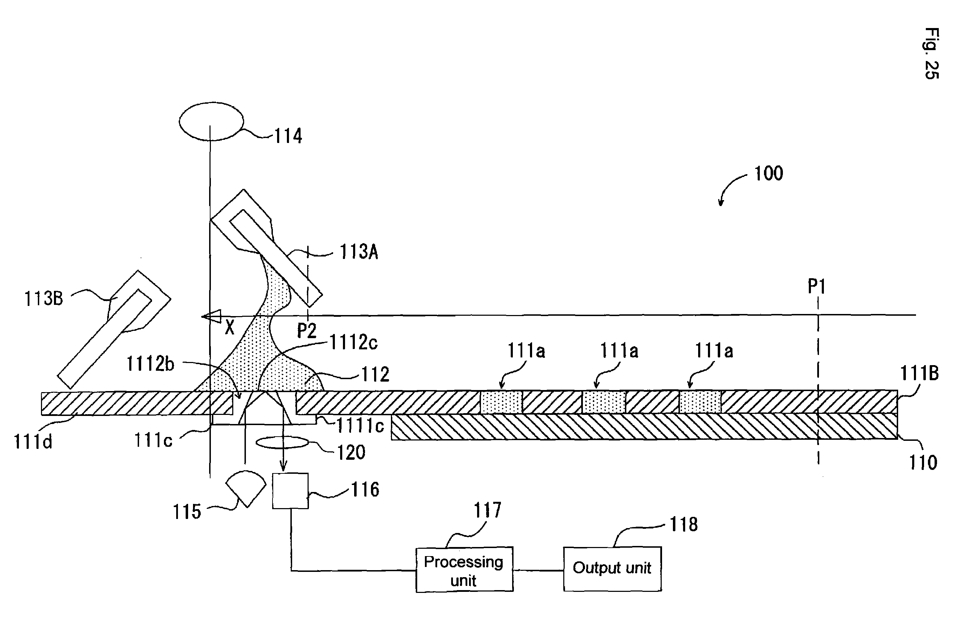

A solder material inspecting device according to a fifth embodiment has a configuration substantially similar to that of the fourth embodiment. However, the solder material inspecting device of the fifth embodiment differs from that of the fourth embodiment in that a second squeegee which squeegees the cream solder after the inspection is further provided, and in the structure of the transmission portion. Only a portion different from that of the fourth embodiment will be described below with reference to Figs. 24 and 25, and the descriptions of other points are omitted. Fig. 24 is a flowchart of the solder material inspecting device of the fifth embodiment. Fig. 25 is a sectional view schematically showing the solder material inspecting device of the fifth embodiment.

In the solder material inspecting device 100 of the fifth embodiment, the squeegee includes a first squeegee 113A and a second squeegee 113B, and the first squeegee 113A performs the print step similar to those of the third embodiment and fourth embodiment.

In a printing mask 111 B, similarly to the fourth embodiment, the hole 1112b is made in the long portion 111d.

In a transmission portion 111 c, an upper side is formed into the substantially same shape as the hole 1112b, and a flange 1111 c is formed on a lower side. The upper side of the transmission portion 111 c is fitted in the hole 1112b, and the transmission portion 111 c is fixed onto the backside of the printing mask 111 B by the flange 1111 c. Similarly to the fourth embodiment, the transmission portion 111 c is formed immediately below the first squeegee 113A lifted at the print end position P2, and the cream solder 112 is placed on the transmission portion 111 c when the squeegee 113A ends the print (hereinafter the surface on which the cream solder is placed is referred to as "placement surface 1112c")

The placement surface 1112c of the transmission portion 111 c is irradiated with the light beam from the backside, and the floodlighting unit 115 and the intensity detecting unit 116 are disposed so as to detect the inspection object intensity of the infrared ray which is as the reflected light beam. Similarly to the fourth embodiment, the improvement of the measurement accuracy is achieved.

On the other hand, the configuration of the fifth embodiment differs from that of the fourth embodiment in that the second squeegee 113B is provided.

After the inspection object intensity is detected, the second squeegee 113B squeegees the cream solder 112 from the placement surface 1112c after the inspection. The second squeegee 113B is made of the same material as the first squeegee 113A. The second squeegee 113B is disposed so as to face the first squeegee 113A, and the second squeegee 113B is inclined toward the direction opposite the first squeegee 113A (toward the side of the direction of print start position P1 in Fig. 25). When the second squeegee 113B which squeegees the cream solder 112 after the inspection is provided, while the second squeegee 113B squeegees the cream solder 112, the first squeegee 113A can be returned to the print start position P1 for the purpose of the next print. As a result, the work efficiency is improved in the print step and the inspection step.

In the solder material inspecting device of the fifth embodiment, the second squeegee 113B squeegees the cream solder 112 of the inspection object placed on the transmission portion 111 c after the intensity detecting unit 116 detects the inspection object intensity, and the intensity detecting unit 116 sends the detection completion signal indicating the detection completion to the second squeegee 113B through the processing unit 117 after the inspection object intensity is detected. The second squeegee 113B starts the squeegeeing work when receiving the detection completion signal.

Alternatively, the second squeegee 113B squeegees the cream solder 112 after the inspection and is slid on the surface of the printing mask 111 B in the opposite direction to the print direction of the first squeegee 113A, and the cream solder 112 can be printed on the board 110. Therefore, the work efficiency is further improved in the print step and the inspection step.

Preferably the transmission portion is set immediately near the squeegee or the print end position P2 of the first squeegee. This is because the cream solder is pressed against the transmission portion by the self weight.

An operation of the solder material inspecting device of the fifth embodiment will be described below with reference to Fig. 24.

A series of operations (S200 to S208) until the output unit 118 supplies the measurement result after the intensity detecting unit 116 detects that the first squeegee 113A ends the print (S200) is similar to that of the third embodiment of Fig. 22. In addition to the series of operations, the squeegeeing operation performed by the second squeegee 113B is added in the fifth embodiment. Specifically, in the squeegeeing operation, when the processing unit 117 receives the light acceptance signal from the intensity detecting unit 116, the processing unit 117 sends a squeegeeing instruction signal to the second squeegee 113B to squeegee the cream solder after the measurement. Then, the second squeegee 113B receives the squeegeeing instruction signal, and is slid on the surface of the printing mask 111 B in the opposite direction to the print direction of the first squeegee 113A to squeegee the cream solder after the inspection (S209). Design of the squeegeeing operation can be changed at proper timing from S206 of Fig. 24.

Furthermore, in the case where the second squeegee 113B is also used in the print step as described above, the same configuration as the transmission portion 111 c is also formed on the side of the print start position P1 of the printing mask 111 B, and the floodlighting unit 115 and the intensity detecting unit 116 are disposed according to the configuration. Therefore, the second squeegee 113B is slid on the surface of the printing mask 111 B from the side of the print end position P2 of Fig. 25 toward the side of the print start position P1, the second squeegee 113B squeegees the cream solder 112 on the placement surface 1112c and sequentially fills the pattern holes 111 a, 111 a, and ... with the squeegeed cream solder 112 from the print end position P2 of Fig. 25, and prints the cream solder 112 on the board 110. Consequently, because the print and the inspection are continuously performed, the print and the inspection are performed more efficiently. The configuration can be applied to the fourth embodiment.

Preferably the placement surface 1112c is formed flush with the surface of the printing mask 111 B. Therefore, the second squeegee 113B easily squeegees the cream solder 112 placed on the placement surface 1112c after the inspection.

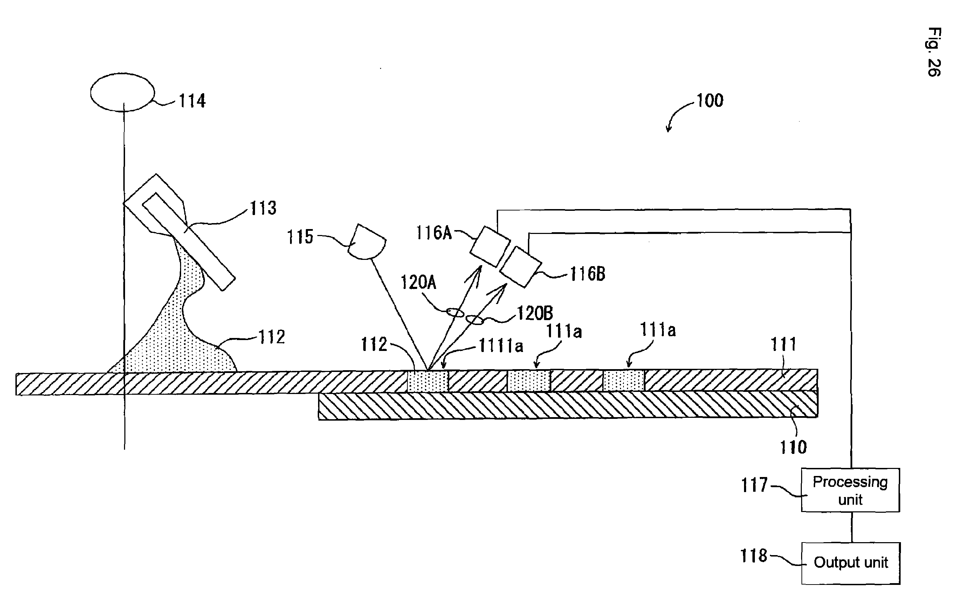

Noncontact measurement methods according to other embodiments will be described with reference to Figs. 26, 27, and 28.

[Sixth Embodiment]

As shown in Fig. 26, plural intensity detecting units 116 and plural bandpass filters 120 may be provided. In the configuration of Fig. 26, for example, a specific wave number of a bandpass filter 120A is set to a wave number at which the metal oxide infrared absorption is observed, and a specific wave number of a bandpass filter 120B is set to a wave number at which the carboxylic acid infrared absorption is observed. Therefore, the metal oxide content and carboxylic acid content can be analyzed in the inspection object.

[Seventh Embodiment]

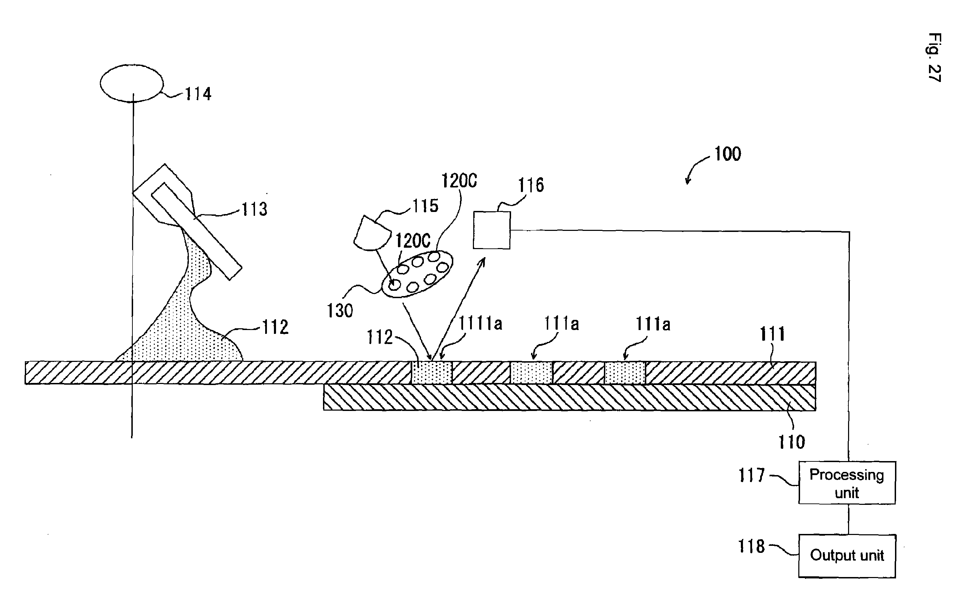

As shown in Fig. 27, a rotary member 130 including plural bandpass filters 120C, and ... may be provided between the floodlighting unit 115 and the printing mask 111 and on the optical axis of the floodlighting unit 115. In the rotary member 130, only one of the bandpass filters 120C is disposed on the optical axis of the floodlighting unit 115. The rotary member 130 is rotated based on a command from the processing unit 117, thereby changing the bandpass filter 120C disposed on the optical axis.

According to the configuration of Fig. 27, the infrared rays having different wave numbers which are reflected from the cream solder 112 can be detected when the bandpass filters 120C, and ... included in the rotary member 130 have the different specific wave numbers. Therefore, the metal oxide content, carboxylic acid content, and carboxylate content of the cream solder 112 of the inspection object can be analyzed by one-time inspecting work.

An optical filter which transmits the infrared ray having the reference data wave number described in the third embodiment may be included in each of the bandpass filters 120C, and ... of the rotary member 130. The intensity detecting unit 116 detects the intensity (fourth intensity) of the reference wave number in the infrared ray reflected from the comparison object and the intensity (third intensity) of the reference wave number in the infrared ray reflected from the inspection object. When the processing unit 117 computes the equations (61) to (64) and the equations (71) to (78), the correction intensity difference, the correction intensity ratio, the correction absorbance difference, and the correction absorbance ratio can be supplied.

[Eighth Embodiment]

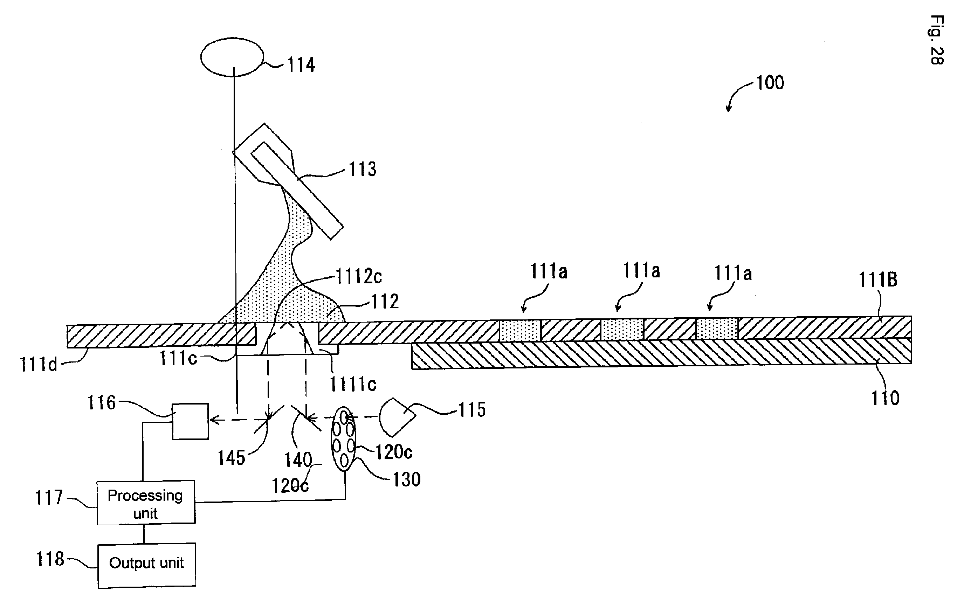

A contact measurement method according to still another embodiment will be described with reference to Fig. 28.
The floodlighting unit 115, the rotary member 130, the intensity detecting unit 116, and mirrors 140 and 145 are disposed while facing one of surfaces of the printing mask 111 B. Specifically, the rotary member 130 and the mirror 140 are disposed on the optical axis of the floodlighting unit 115 in this order along the light beam proceeding direction from the floodlighting unit 115. The mirror 140 is disposed such that the light beam emitted from the floodlighting unit 115 is reflected toward the direction of the transmission portion 111c through the rotary member 130. The mirror 145 is disposed such that the light beam from the transmission portion 111 c is reflected toward the direction of the intensity detecting unit 116.
According to the configuration of Fig. 28, the bandpass filter 120C included in the rotary member 130 transmits only the infrared ray having the specific wave number in the light beam emitted from the floodlighting unit 115, and transmitted infrared ray is guided to the mirror 140. The infrared ray is reflected by the mirror 140 and guided to the direction of the transmission portion 111 c, and reaches the cream solder 112 through the transmission portion 111 c. The infrared ray which reaches the cream solder 112 is reflected and guided to the mirror 145 through the transmission portion 111 c. The infrared ray guided to the mirror 45 is reflected by the mirror 145, and is incident to the intensity detecting unit 116. Therefore, the intensity detecting unit 116 can detect the intensity of the infrared ray reflected from the cream solder 112.
The invention is not limited to the embodiments, various changes can be made within a scope of claims, and an embodiment obtained by a proper combination of technical means disclosed in the embodiments also included in the technical range of the invention. This application is based upon and claims the benefit of priority from the prior Japanese Patent Application Nos. 2005-330281, filed November 15, 2005, and 2005-337790, filed November 22, 2005, and the entire contents of which are incorporated herein by reference.

**Claims**

1. A solder material inspecting device including:

    printing position obtaining means for obtaining information on a printing position of a solder material printed on a board;
    a light source which emits a light beam only to the solder material printed on the board while scanning the board with the light beam based on the printing position information obtained by the printing position obtaining means; and
    an intensity detecting unit which detects inspection object intensity of an infrared ray having a specific wave number, the infrared ray being reflected from the solder material by the emission of the light beam from the light source, wherein
    an absorbance of the infrared ray having the specific wave number in the solder material of the inspection object and the inspection object intensity are supplied as measurement values, the absorbance being obtained based on the inspection object intensity.

2. The solder material inspecting device according to claim 1, wherein the light source intermittently emits the light beam.

3. The solder material inspecting device according to claim 1, including light shielding means for intermittently shielding the light beam emitted from the light source.

4. A solder material inspecting device including:

    a light source which emits a light beam to a board before reflow while scanning the board with the light beam, at least a solder material being printed on the board;
    an intensity detecting unit which detects measurement intensity, the measurement intensity being intensity of an infrared ray having a specific wave number, the infrared ray being reflected from the board by the emission of the light beam from the light source, the solder material being printed on the board; and

intensity extraction means for extracting inspection object intensity of the infrared ray having the specific wave number from the measurement intensity detected by the intensity detecting unit, the infrared ray being a reflected light beam detected only from the solder material, wherein

an absorbance of the infrared ray having the specific wave number in the solder material of the inspection object and the inspection object intensity are supplied as measurement values, the absorbance being obtained based on the inspection object intensity.

5. The solder material inspecting device according to claim 4, including a storage unit in which intensity of the infrared ray having the specific wave number is stored as board intensity, the intensity of the infrared ray being reflected from a board irradiated with the light beam, wherein

the intensity extraction means extracts the inspection object intensity by computing a difference between the measurement intensity and the board intensity stored in the storage unit.

6. The solder material inspecting device according to claim 4, including a storage unit in which intensity of the infrared ray having the specific wave number is previously stored as solder intensity, the intensity of the infrared ray being reflected from a solder material irradiated with the light beam, wherein

the intensity extraction means extracts the inspection object intensity by comparing an increasing and decreasing pattern of a signal of the solder intensity stored in the storage unit to an increasing and decreasing pattern of a signal of the measurement intensity.

7. The solder material inspecting device according to claim 1, including an input unit which can specify a measurement object area in the solder material printed on the board, the measurement object area being a range scanned by the light source.

8. A solder material inspecting device inspecting a degree of deterioration of a solder material by using a printing mask and a squeegee, the solder material being printed on a board with a pattern hole filled therewith, the printing mask having at least one pattern hole while being overlapped on the board, the squeegee being slid on a surface of the printing mask surface,

the solder material inspecting device including:

a detection unit which detects that the squeegee ends the print;
a floodlighting unit which emits a light beam to a solder material of an inspection object when receiving a signal of the print end from the detection unit; and
an intensity detecting unit which detects inspection object intensity of an infrared ray having a specific wave number, the infrared ray being reflected from the solder material of the inspection object by the emission of the light beam, wherein
at least one of an absorbance of the infrared ray having the specific wave number in the solder material of the inspection object and the inspection object intensity is supplied as a measurement value, the absorbance being obtained based on the inspection object intensity.

9. The solder material inspecting device according to claim 8, wherein the solder material inspecting device sets a reference wave number which is a wave number different from the specific wave number,

the intensity detecting unit detects inspection object reference intensity of the infrared ray having the reference wave number, the infrared ray being reflected from the solder material of the inspection object, and

the solder material inspecting device corrects at least one of the inspection object intensity and a comparison object intensity according to a degree of a difference between comparison object reference intensity of the infrared ray having the reference wave number and the inspection object reference intensity, the comparison object reference intensity of the infrared ray being detected as a light beam reflected from the solder material of the inspection object to the solder material of the inspection object when a solder material of a comparison object is irradiated with the light beam.

10. The solder material inspecting device according to claim 8, wherein the solder material of the inspection object is one with which an inspection hole in the pattern holes is filled.

11. The solder material inspecting device according to claim 8, wherein, while the printing mask is formed longer in a print direction of the squeegee rather than the board when the printing mask is overlapped on the board, a transmission unit is provided in a portion where the printing mask is not overlapped on the board,
the solder material of the inspection object is placed on the transmission unit by the squeegee at a time the print is ended, and
the floodlighting unit emits the light beam from a backside of the printing mask to the solder material of the inspection object placed on the transmission unit when receiving the signal of the print end from the detection unit.

12. The solder material inspecting device according to claim 11, wherein the transmission unit is placed at a printing end position of the squeegee or the first squeegee.

13. The solder material inspecting device according to claim 11, wherein, in the transmission unit, a surface on which the solder material of the inspection object is placed is made flush with the printing mask surface.

14. The solder material inspecting device according to claim 11, wherein the transmission unit is formed by a prism.

Fig. 1

EP 1 953 534 A1

Measurement start position P1(X0,Y0)

1 Solder material inspecting device

Positioning marker P0(0,0)

21

Infrared ray

X

Moving direction

22

Measurement object area A

3

20

3

Solder paste

12

11

2

Y

3

Y

20

3

X

Moving direction

11

Fig. 2

1 Solder material
inspecting device

Storage unit — 30

Moving unit
(X stage and Y
stage) — 10

Control unit — 50

Infrared
spectroscopic
measurement unit — 20

Solder deterioration
computing unit — 60

Input unit — 40

Output unit — 70

Fig. 3 (a)

Measurement object area A

3-1  3-2  3-3  3-4  3-5  3-6  3-7

Fig. 3 (b)

Light

L1 L2 L3 L4 L5 L6 L7 L8 L9 L10 L11 L12 L13

ON

OFF

X

Fig. 4

| Input unit 40 | Control unit 50 | Storage unit 30 |
|---|---|---|
| Specify measurement object area — S400 | Compute illumination light emission pattern — S402 | CAD data board or mask — S401 |
| | Read / Write | Illumination light emission pattern and measurement object area — S403 |
| End | End | End |

Fig. 5

Fig. 5 — Sequence/flow diagram with columns: Moving unit (10), Control unit (50), Storage unit (30), Infrared spectroscopic measurement unit (20), Solder deterioration computing unit (60).

- S500: Read out illumination light emission pattern and measurement object area
- S501: Provide moving instruction to (X0,Y0)
- S502: Move X-stage and Y-stage to start position
- S503: Start measurement and movement
- S504: Provide information on X-stage moving position
- S505: Emit light beam based on X position and light emission pattern, and perform continuous measurement
- S506: Write continuously measurement data
- S507: End movement
- S508: Start computation of degree of deterioration of solder
- S509: Read out measurement data and reference solder data
- S510: Compute degree of deterioration of solder in object area
- S511: Write deterioration degree data
- S512: Output processing
- End

Fig. 6

Fig. 7

| Chemical name | Chemical formula | Content (wt%) |
|---|---|---|
| Tin | Sn | 80 - 90 |
| Silver | Ag | 1 - 3 |
| Copper | Cu | Lower than 1 |
| Diethylene glycol monohexyl ether | $C_6H_{13}(OCH_2CH_2)_2-OH$ | 2 - 4 |
| 2-ethyl-1,3-hexanediol | $C_3H_7CH(OH)CH(C_2H_5)CH_2OH$ | Lower than 1 |
| Rosin | $C_{19}H_{29}COOH$ | 4 - 6 |

Fig. 8

Fig. 9 (a)

Fig. 9 (b)

| Number of print times | | 200 | 400 | 600 | 800 | 1000 | 1200 |
|---|---|---|---|---|---|---|---|
| Viscosity $[Pa \cdot s]$ | | 178.5 | 212 | 282.3 | 353.5 | 450.8 | 640 |
| Wave number $[cm-1]$ | 1600[cm-1] | 0.00901 | 0.01309 | 0.01587 | 0.01982 | 0.02145 | 0.02308 |
| | 1700[cm-1] | -0.00858 | -0.01016 | -0.01434 | -0.01514 | -0.01997 | -0.02656 |

Fig. 10

Wave number [cm−1]

| Number of print times of inspection object | |
|---|---|
| ——— | 200 times |
| ——— | 400 times |
| ——— | 600 times |
| ——— | 800 times |
| ——— | 1000 times |
| ------ | 1200 times |

Fig. 11

Fig. 12

Fig. 13

Fig. 14

EP 1 953 534 A1

1 Solder material inspecting device

Fig. 15

Fig. 16

Fig. 17

Fig. 18

Fig. 19

Fig. 20

100

Output unit — 118

Measurement result

Processing unit — 117

Light acceptance signal

Intensity detecting unit — 116

Light emission command

Floodlighting unit — 115

Print completion detection signal

Detection unit — 114

Fig. 21

| 118 | 116 | 115 | 117 | 114 |
|---|---|---|---|---|
| Output unit | Intensity detecting unit | Floodlighting unit | Processing unit | Detection unit |

Measurement result

Light acceptance signal

Light emission command

Print completion detection signal

Fig. 22

EP 1 953 534 A1

START

S100 — (1) Detect print completion with detection unit

S101 — (2) Notify print completion from detection unit to processing unit

S102 — (3) Provide light emission instruction from processing unit to floodlighting unit

S103 — (4) Emit light beam with floodlighting unit

S104 — (5) Accept light beam from floodlighting unit with light acceptance unit

(6) Receive light acceptance signal from light acceptance unit with processing unit — S105

(7) Compute degree of state change from light acceptance signal with processing unit — S106

(8) Transfer degree of state change from processing unit to output unit — S107

(9) Supply measurement result with output unit — S108

END

Fig. 23

Fig. 24

EP 1 953 534 A1

```
                    ┌─────────────┐
                    │    START    │
                    └─────────────┘
                           │
                           ▼
          ┌────────────────────────────────┐
  S200    │ (1) Detect print completion of first
          │ squeegee with detection unit   │
          └────────────────────────────────┘
                           │
                           ▼
          ┌────────────────────────────────┐
  S201    │ (2) Notify print completion from
          │ detection unit to processing unit │
          └────────────────────────────────┘
                           │
                           ▼
          ┌────────────────────────────────┐
  S202    │ (3) Provide light emission
          │ instruction from processing unit to
          │ floodlighting unit             │
          └────────────────────────────────┘
                           │
                           ▼
          ┌────────────────────────────────┐
  S203    │ (4) Emit light beam with
          │ floodlighting unit             │
          └────────────────────────────────┘
                           │
                           ▼
          ┌────────────────────────────────┐
  S204    │ (5) Accept light beam from
          │ floodlighting unit with light
          │ acceptance unit                │
          └────────────────────────────────┘
```

(1) Detect print completion of first squeegee with detection unit — S200

(2) Notify print completion from detection unit to processing unit — S201

(3) Provide light emission instruction from processing unit to floodlighting unit — S202

(4) Emit light beam with floodlighting unit — S203

(5) Accept light beam from floodlighting unit with light acceptance unit — S204

(6) Receive light acceptance signal from light acceptance unit with processing unit — S205

(7) Compute degree of state change from light acceptance signal with processing unit — S206

(8) Transfer degree of state change from processing unit to output unit — S207

(9) Supply measurement result with output unit — S208

(10) Squeegee measurement solder with second squeegee — S209

END

Fig. 25

Fig. 26

EP 1 953 534 A1

Fig. 27

EP 1 953 534 A1

Fig. 28

EP 1 953 534 A1

<table>
<tr><td colspan="2">**INTERNATIONAL SEARCH REPORT**</td><td>International application No.<br>PCT/JP2006/322390</td></tr>
</table>

| | |
|---|---|
| A. CLASSIFICATION OF SUBJECT MATTER<br>*G01N21/35(2006.01)i* | |

According to International Patent Classification (IPC) or to both national classification and IPC

**B. FIELDS SEARCHED**

Minimum documentation searched (classification system followed by classification symbols)
*G01N21/00-G01N21/958*

Documentation searched other than minimum documentation to the extent that such documents are included in the fields searched
Jitsuyo Shinan Koho     1922-1996   Jitsuyo Shinan Toroku Koho   1996-2007
Kokai Jitsuyo Shinan Koho  1971-2007   Toroku Jitsuyo Shinan Koho   1994-2007

Electronic data base consulted during the international search (name of data base and, where practicable, search terms used)
WPI, IEEE, JST7580(JDream2), JSTPlus(JDream2)

**C. DOCUMENTS CONSIDERED TO BE RELEVANT**

| Category* | Citation of document, with indication, where appropriate, of the relevant passages | Relevant to claim No. |
|---|---|---|
| A | WO 2004/023122 A (Hamamatsu Foundation for Science and Technology Promotion),<br>18 March, 2004 (18.03.04),<br>Example 1 to 2; Fig. 2 | 1 |
| A | JP 2002-350342 A (Advantest Corp.),<br>04 December, 2002 (04.12.02),<br>Par. Nos. [0028] to [0043]; Fig. 1 | 2-3 |
| A | JP 2005-164455 A (Matsushita Electric Industrial Co., Ltd.),<br>23 June, 2005 (23.06.05),<br>Par. Nos. [0029] to [0030]; Fig. 9 | 7 |

☒ Further documents are listed in the continuation of Box C.     ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>12 January, 2007 (12.01.07) | Date of mailing of the international search report<br>23 January, 2007 (23.01.07) |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/322390 |

C (Continuation).   DOCUMENTS CONSIDERED TO BE RELEVANT

| Category* | Citation of document, with indication, where appropriate, of the relevant passages | Relevant to claim No. |
| --- | --- | --- |
| P,A | JP 3775426 B1  (Omron Corp.),<br>17 May, 2006 (17.05.06),<br>Par. No. [0094] | 1 |
| A | JP 3-108639 A  (Nippon Steel Corp.),<br>08 May, 1991 (08.05.91),<br>Page 2, upper right column, | 1 |
| A | Kaoru UEDA et al., "Suibun Kansodo Censor<br>no Kaihatsu (II)", Reports of Kyoto<br>PrefecturalTechnology Center for Small and<br>Medium Enterprises [ISSN:0916-6742],<br>Vol.29, 2001, pp.94-96 | 1 |
| A | C. Bocking, "Rising to the surface",<br>Transactions of the Institute of Metal<br>Finishing, Vol.79, No.6, 2001, pp.B97-B99 | 1 |

Form PCT/ISA/210 (continuation of second sheet) (April 2005)

**INTERNATIONAL SEARCH REPORT**
Information on patent family members

International application No.

PCT/JP2006/322390

| | | | |
|---|---|---|---|
| WO 2004/023122 A1 | 2004.03.18 | AU 2003261884 A1 | 2004.03.29 |
| JP 2002-350342 A | 2002.12.04 | (Family: none) | |
| JP 2005-164455 A | 2005.06.23 | (Family: none) | |
| JP 3775426 B1 | 2006.05.17 | CN 1825088 A | 2006.08.30 |
| | | EP 1693666 A1 | 2006.08.23 |
| | | JP 2006-234447 A | 2006.09.07 |
| JP 3-108639 A | 1991.05.08 | JP 5-074019 B | 1993.10.15 |

Form PCT/ISA/210 (patent family annex) (April 2005)

## INTERNATIONAL SEARCH REPORT

International application No.

PCT/JP2006/322390

**Box No. II     Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III     Observations where unity of invention is lacking (Continuation of item 3 of first sheet)**

This International Searching Authority found multiple inventions in this international application, as follows:
The search has revealed that the matter common to all (1) claims 1-3, 7 (2) claims 4-6, and (3) claims 8-14 is not novel since it is disclosed in, for example, the document below.
WO 2004/23122 A (Hamamatsu Foundation for Science and Technology Promotion), 18 March, 2004 (18.03.04), examples 1-2, figure 2
Therefore, since there exits no common matter considered as a special technical feature, the above (1) to (3) obviously do not satisfy the unity of invention.

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.: 1-3, 7

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

**REFERENCES CITED IN THE DESCRIPTION**

**Patent documents cited in the description**

- JP 8020434 A
- JP 5099831 A
- JP 10082737 A
- JP 2005330281 A
- JP 2005337790 A